# EUROPEAN PATENT SPECIFICATION

(11) **EP 4 362 648 B1**
(45) Date of publication and mention of the grant of the patent: **06.08.2025**
(21) Application number: 23190998.7
(22) Date of filing: 11.08.2023
(51) Int. Cl.: H10N 30/071, H10N 30/072, H10N 39/00, H01L 21/78, H01L 21/683, H10H 20/01

(54) **MANUFACTURING METHOD OF ELECTRONIC DEVICE**
HERSTELLUNGSVERFAHREN FÜR EINE ELEKTRONISCHE VORRICHTUNG
PROCÉDÉ DE FABRICATION D'UN DISPOSITIF ÉLECTRONIQUE

(30) Priority: 26.10.2022 JP 2022171093
(43) Date of publication of application: 01.05.2024
(73) Proprietor: Oki Electric Industry Co., Ltd., Minato-ku Tokyo 105-8460 (JP)
(72) Inventor: FURUTA, Hironori, Tokyo, 105-8460 (JP); ISHIKAWA, Takuma, Tokyo, 105-8460 (JP); SHINOHARA, Yuuki, Tokyo, 105-8460 (JP); SUZUKI, Takahito, Tokyo, 105-8460 (JP); TANIGAWA, Kenichi, Tokyo, 105-8460 (JP); KITAJIMA, Yutaka, Tokyo, 105-8460 (JP)
(74) Representative: Betten & Resch

(56) References cited:
- JP-A- 2015 126 188
- US-A1- 2020 321 487
- US-A1- 2022 005 699

## Description

### BACKGROUND OF THE INVENTION

### 1. Field of the Invention

The present invention relates to a manufacturing method of an electronic device.

### 2. Description of the Related Art

Conventionally, there has been known a technology of peeling off a prescribed element from a substrate and transferring the element to a different substrate. This technology is described in US 2022/0005699 A1, US 2020/0321487 A1, JP 2015 126188 A, and Japanese Patent application publication No. 2009-152387.

### SUMMARY OF THE INVENTION

However, in the conventional technology, there is a problem in that cracking or the like of the element is likely to occur when the element is transferred and it is difficult to increase the manufacturing yield.

The object of the present invention is to prevent the cracking or the like of a functional layer occurring when the functional layer is transferred and to increase the manufacturing yield.

A manufacturing method of an electronic device is defined in the independent method claim 1.

According to the present invention, since the functional layer is separated from the first substrate and is transferred to the second substrate in a state in which the functional layer is held by the thin film holding layer, the cracking or the like of the functional layer can be prevented, by which the manufacturing yield can be increased.

### BRIEF DESCRIPTION OF THE DRAWINGS

FIG. 1 is a flowchart showing a manufacturing method of an electronic device in a first embodiment.
FIGS. 2(A) and 2(B) are cross-sectional views schematically showing a process of forming a functional layer on a first substrate and a process of separating (singulating) the functional layer in the manufacturing method of the electronic device in the first embodiment.
FIGS. 3(A), 3(B) and 3(C) are a cross-sectional view, a plan view and a partial enlarged view schematically showing a process of forming a support layer in the manufacturing method of the electronic device in the first embodiment.
FIGS. 4(A) and 4(B) are a cross-sectional view and a plan view schematically showing a process of forming a thin film holding layer in the manufacturing method of the electronic device in the first embodiment.
FIGS. 5(A), 5(B) and 5(C) are cross-sectional views schematically showing a process of removing a release layer, a process of separating the functional layer, the support layer and the thin film holding layer from the first substrate, and a process of transferring the functional layer, the support layer and the thin film holding layer to a second substrate in the manufacturing method of the electronic device in the first embodiment.
FIGS. 6(A) and 6(B) are a cross-sectional view and a plan view schematically showing a process of removing the thin film holding layer in the manufacturing method of the electronic device in the first embodiment.
FIGS. 7(A), 7(B) and 7(C) are a cross-sectional view, a plan view and another cross-sectional view schematically showing a process of forming an electrode and a wiring on the functional layer in the manufacturing method of the electronic device in the first embodiment.
FIGS. 8(A), 8(B) and 8(C) are a cross-sectional view, a plan view and a schematic diagram schematically showing a process of removing the release layer in a manufacturing method of an electronic device in a comparative example.
FIGS. 9(A) and 9(B) are a cross-sectional view and a plan view schematically showing another example of the process of removing the release layer, and FIG. 9(C) is a cross-sectional view schematically showing still another example of the process of removing the release layer in the manufacturing method of the electronic device in the first embodiment.
FIG. 10 is a flowchart showing a manufacturing method of an electronic device in a second embodiment.
FIGS. 11(A) and 11(B) are cross-sectional views schematically showing a process of forming a functional layer on a first substrate and a process of separating (singulating) the functional layer in the manufacturing method of the electronic device in the second embodiment.
FIGS. 12(A), 12(B) and 12(C) are a cross-sectional view, a plan view and a partial enlarged view schematically showing a process of forming a support layer in the manufacturing method of the electronic device in the second embodiment.
FIGS. 13(A) and 13(B) are a cross-sectional view and a plan view schematically showing a process of forming a thin film holding layer in the manufacturing method of the electronic device in the second embodiment.
FIGS. 14(A), 14(B) and 14(C) are cross-sectional views schematically showing a process of removing a release layer, a process of separating the functional layer, the support layer and the thin film holding layer from the first substrate, and a process of transferring the functional layer, the support layer and the thin film holding layer to a second substrate in the manufacturing method of the electronic device in the second embodiment.
FIGS. 15(A) and 15(B) are a cross-sectional view and a plan view schematically showing a process of removing the thin film holding layer in the manufacturing method of the electronic device in the second embodiment.
FIG. 16 is a cross-sectional view schematically showing a process of patterning the functional layer on the second substrate and removing the support layer in the manufacturing method of the electronic device in the second embodiment.
FIGS. 17(A), 17(B) and 17(C) are a cross-sectional view, a plan view and another cross-sectional view schematically showing a process of forming an electrode and a wiring on the functional layer in the manufacturing method of the electronic device in the second embodiment.
FIG. 18 is a flowchart showing a manufacturing method of an electronic device in a third embodiment.
FIGS. 19(A), 19(B) and 19(C) are cross-sectional views schematically showing a process of removing the release layer, a process of joining a third substrate to the thin film holding layer on a selected functional layer, and a process of separating the functional layer, the support layer and the thin film holding layer from the first substrate in the manufacturing method of the electronic device in the third embodiment.
FIGS. 20(A) and 20(B) are cross-sectional views schematically showing a process of transferring the functional layer, the support layer and the thin film holding layer to the second substrate and a process of removing the thin film holding layer in the manufacturing method of the electronic device in the third embodiment.
FIGS. 21(A) and 21(B) are cross-sectional views schematically showing a process of joining the third substrate to the thin film holding layer on another selected functional layer and a process of separating the functional layer, the support layer and the thin film holding layer from the first substrate in the manufacturing method of the electronic device in the third embodiment.
FIGS. 22 (A) and 22(B) are cross-sectional views schematically showing a process of transferring the functional layer, the support layer and the thin film holding layer to a second substrate and a process of removing the thin film holding layer in the manufacturing method of the electronic device in the third embodiment.
FIG. 23 is a plan view schematically showing a process of forming an electrode and a wiring on the functional layer in the manufacturing method of the electronic device in the third embodiment.

### DETAILED DESCRIPTION OF THE INVENTION

A manufacturing method of an electronic device according to each embodiment will be described below with reference to the drawings. The following embodiments are just examples and a variety of modifications are possible within the scope of the present invention.

### (First Embodiment)

### <Manufacturing Method of Electronic Device>

An electronic device in a first embodiment is a piezoelectric device including a piezoelectric element, for example. The piezoelectric device is used for a piezoelectric module. The piezoelectric module is a piezoelectric sensor, an actuator, an ultrasonic sensor, an ultrasonic generator, a pressure transducer or the like, for example.

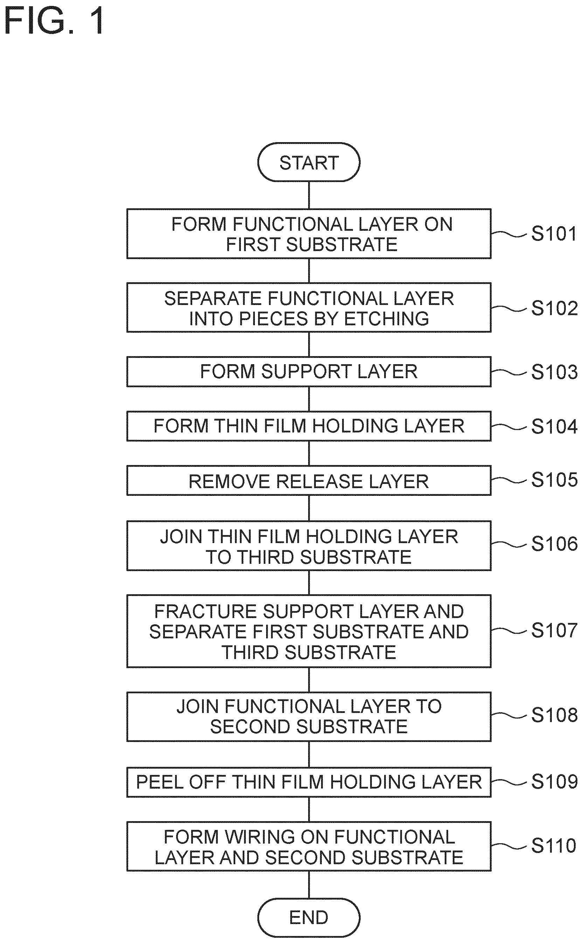

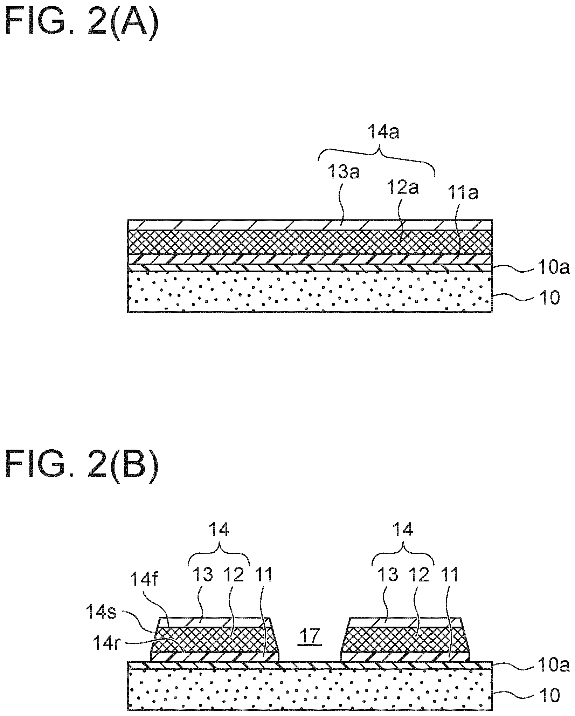

FIG. 1 is a flowchart showing a manufacturing method of an electronic device in the first embodiment. FIGS. 2(A) and 2(B) are cross-sectional views schematically showing a process of forming a release layer 11a and a functional layer 14a which will be described later on a first substrate 10 and a process of separating (singulating) the release layer 11a and the functional layer 14a by means of etching.

In step S101 (FIG. 1), as shown in FIG. 2(A), the release layer 11a, a crystalline thin-film layer 12a and an upper electrode layer 13a are formed on the first substrate 10. Among these layers, the crystalline thin-film layer 12a and the upper electrode layer 13a are referred to collectively as the functional layer 14a. Incidentally, the functional layer 14a may also be formed of the crystalline thin-film layer 12a alone.

The first substrate 10 is a growth substrate (wafer) on whose front surface the crystalline thin-film layer 12a is grown epitaxially. The first substrate 10 is formed of silicon, silicon dioxide, sapphire or the like, for example.

The crystalline thin-film layer 12a is a crystal layer having a piezoelectric property, for example. The crystalline thin-film layer 12a is formed of, for example, a thin-film crystal such as barium titanate, lead zirconate titanate, zinc oxide, aluminum nitride or lithium tantalate, rock crystal, or the like. The thickness of the crystalline thin-film layer 12a is 500 nm to 10 µm, for example.

To obtain an excellent piezoelectric property, it is desirable to epitaxially grow the crystalline thin-film layer 12a on the first substrate 10 so as to form a single crystal having little lattice mismatch.

For the release layer 11a, it is desirable to select a material whose lattice constant is close to that of the crystalline thin-film layer 12a and whose etching selectivity is high, among oxide films such as magnesium oxide, zircon oxide and aluminum oxide and metals such as molybdenum and titanium, for example.

It is also possible to form a buffer layer 10a having a lattice constant between those of the first substrate 10 and the release layer 11a on the front surface of the first substrate 10 in order to reduce the lattice mismatch between the first substrate 10 and the release layer 11a. The buffer layer 10a may also be a stacked body formed by stacking a plurality of layers differing in the material.

In the following description, the expression "the front surface of the first substrate 10" is intended to mean the front surface of the buffer layer 10a when the first substrate 10 has the buffer layer 10a.

The upper electrode layer 13a is formed of a metal having high electrical conductivity such as platinum, gold, silver, aluminum or copper or an alloy including two or more of these metals. The thickness of the upper electrode layer 13a is 10 nm to 1000 nm, for example. Incidentally, the formation of the upper electrode layer 13a may also be executed after a transfer process onto a second substrate 20 which will be described later.

In the subsequent step S102 (FIG. 1), as shown in FIG. 2(B), grooves 17 are formed by means of photolithography or the like, by which the release layer 11a and the functional layer 14a are separated (singulated) into pieces like islands. While the buffer layer 10a is not separated in this example, it is also possible to further separate the buffer layer 10a.

The release layer 11a after being separated is referred to as a "release layer 11". Similarly, the crystalline thin-film layer 12a after being separated is referred to as a "crystalline thin-film layer 12", and the upper electrode layer 13a after being separated is referred to as an "upper electrode layer 13". A functional layer 14 (referred to also as a "functional thin film") is formed by the crystalline thin-film layer 12 and the upper electrode layer 13. Incidentally, the functional layer 14 may also be formed of the crystalline thin-film layer 12 alone.

The functional layer 14 has a front surface (first surface) 14f on a side opposite to the first substrate 10, a back surface (second surface) 14r on a side facing the first substrate 10, and side faces 14s as inclined surfaces formed between the front surface 14f and the back surface 14r.

While the front surface of the upper electrode layer 13 serves as the front surface 14f of the functional layer 14 in this example, the front surface of the crystalline thin-film layer 12 serves as the front surface 14f of the functional layer 14 when the functional layer 14 does not include the upper electrode layer 13.

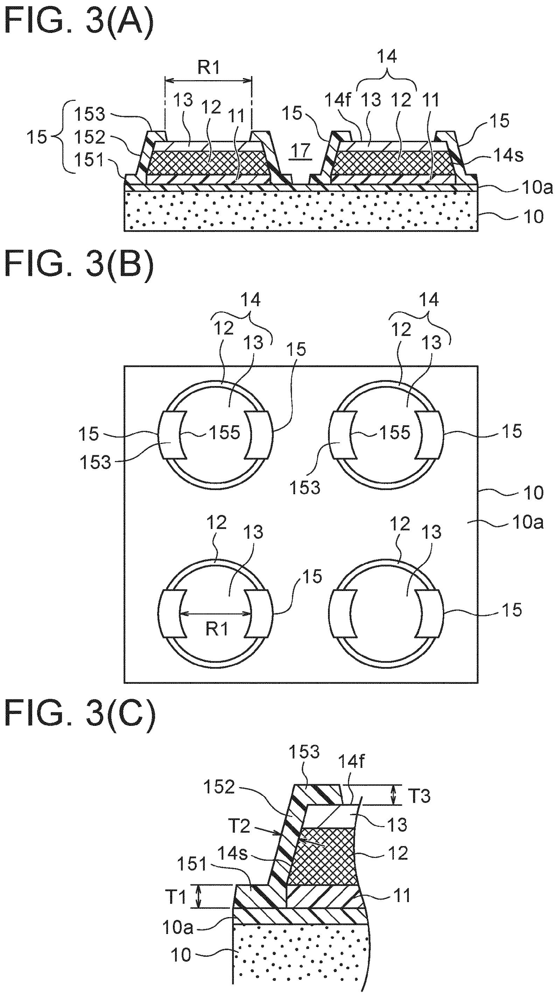

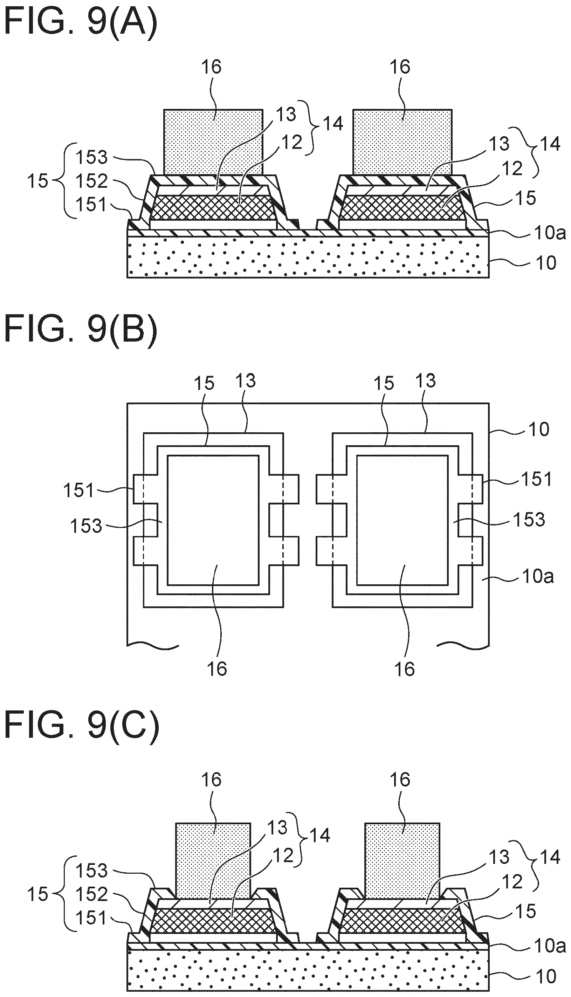

In this example, a two-dimensional shape (shape in a plane parallel to the front surface of the first substrate 10) of the functional layer 14 is a circular shape (see FIG. 3(B)). However, the two-dimensional shape of the functional layer 14 is not limited to a circular shape but may also be a quadrangular shape (see FIG. 9(B)), for example.

FIGS. 3(A) and 3(B) are a cross-sectional view and a plan view schematically showing a process of forming a support layer 15 which will be described below. In step S103 (FIG. 1), the support layer 15 is formed from the front surface 14f of the functional layer 14 to the front surface of the first substrate 10 as shown in FIG. 3(A). The support layer 15 is a part that supports the functional layer 14 with respect to the first substrate 10.

The support layer 15 is deposited by means of CVD (Chemical Vapor Deposition) or the like and thereafter patterned by means of lithography, etching or the like. The support layer 15 is formed of a material having resistance to an etching solution used in a process of removing a release layer 11 which will be described later. As an example, an inorganic insulation film such as an oxide film or a nitride film is desirable for the support layer 15.

The support layer 15 extends from the front surface of the upper electrode layer 13 to the front surface of the first substrate 10 via a side face of the crystalline thin-film layer 12. In other words, the support layer 15 extends from the front surface 14f of the functional layer 14 to the front surface of the first substrate 10 via the side face 14s of the functional layer 14.

As shown in FIG. 3(B), the support layer 15 is provided at two positions in a 180-degree positional relationship with respect to the center of the functional layer 14 in the circular shape. Namely, two support layers 15 are provided for each functional layer 14.

A large proportion of the front surface of the first substrate 10, a large proportion of each of side faces of the release layer 11, the crystalline thin-film layer 12 and the upper electrode layer 13, and a central region of the front surface of the upper electrode layer 13 are not covered by the support layer 15 and are exposed.

On the front surface of the upper electrode layer 13, arc-shaped end parts 155 of the two support layers 15 face each other. The central region (represented by a reference character R1) of the upper electrode layer 13 is the exposed part. This central region is a region in which a wiring is formed in a later process.

Incidentally, the number of support layers 15 for one functional layer 14 is not limited to 2. It is sufficient that one or more support layers 15 are provided for each functional layer 14.

FIG. 3(C) is a cross-sectional view schematically showing a cross-sectional shape of the support layer 15. The support layer 15 includes a first part 151 joined to the front surface of the first substrate 10, a second part 152 joined to the side face 14s of the functional layer 14, and a third part 153 joined to the front surface 14f of the functional layer 14.

The first part 151, the second part 152 and the third part 153 respectively have thicknesses T1, T2 and T3. The thickness T2 of the second part 152 is less than the thickness T1 of the first part 151 and less than the thickness T3 of the third part 153. In other words, the support layer 15 is configured so that the second part 152 is the most likely to be fractured.

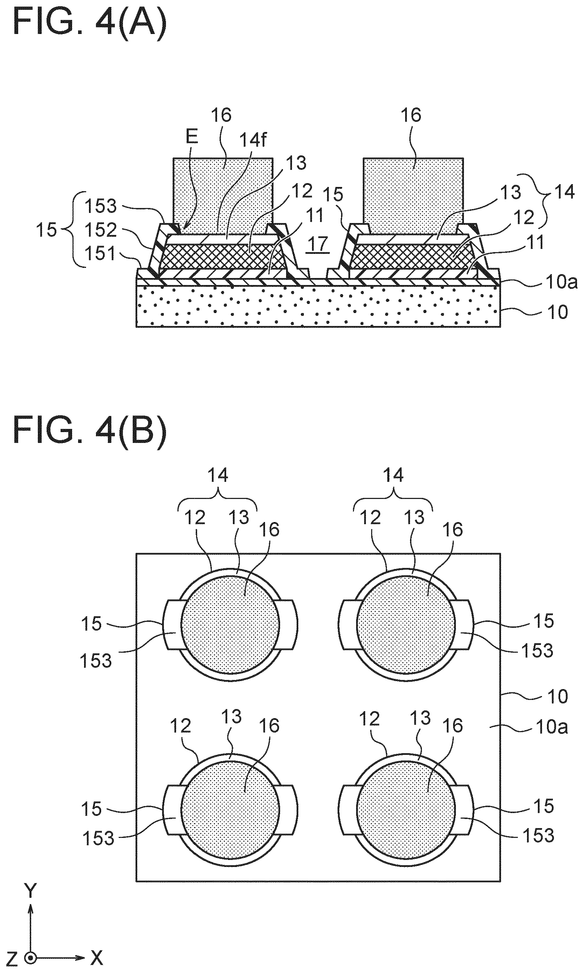

FIGS. 4(A) and 4(B) are a cross-sectional view and a plan view schematically showing a process of forming a thin film holding layer 16 which will be explained next. In step S104 (FIG. 1), the thin film holding layer 16 is formed on the functional layer 14 as shown in FIG. 4(A).

The thin film holding layer 16 is an organic structure and is formed of a material that has resistance to the etching solution used in the process of removing the release layer 11 which will be described later and that can be removed by using a stripper solution different from the etching solution. As an example, a photosensitive organic resist, silicone resin or the like is desirable for the thin film holding layer 16.

The thin film holding layer 16 is formed by depositing an organic resist or the like to cover the support layer 15 and the functional layer 14 on the first substrate 10 and patterning the deposited film by photolithography.

The thin film holding layer 16 is formed to be thicker than the functional layer 14, so that the thin film holding layer 16 has higher bending strength and shear strength than the functional layer 14. As an example, the thickness of the thin film holding layer 16 is 3 to 10 times the thickness of the functional layer 14.

Further, the linear expansion coefficient of the thin film holding layer 16 is desired to be less than the linear expansion coefficient of the crystalline thin-film layer 12 so that the crystalline thin-film layer 12 does not warp toward the first substrate 10 in the process of removing (etching) the release layer 11 which will be described later.

The thin film holding layer 16 is formed to cover a boundary part (represented by a reference character E in FIG. 4(A)) between the front surface 14f of the functional layer 14 (the front surface of the upper electrode layer 13) and the support layer 15. With this configuration, cracking that is likely to occur in the boundary part can be prevented effectively.

Further, the area of the thin film holding layer 16 is smaller than the area of the front surface 14f of the functional layer 14. Accordingly, the thin film holding layer 16 is prevented from hanging down toward the side face of the crystalline thin-film layer 12.

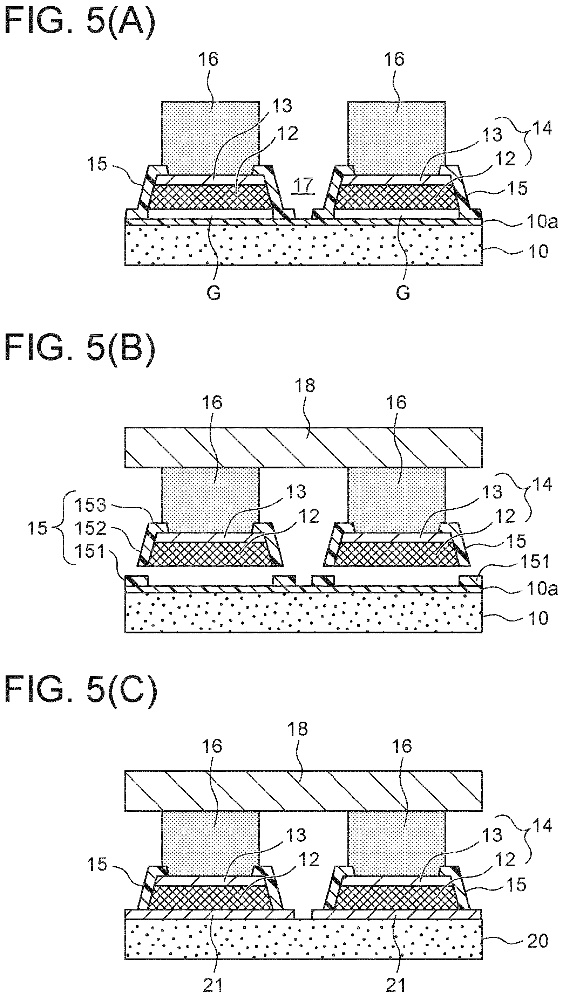

FIGS. 5(A), 5(B) and 5(C) are cross-sectional views schematically showing a process of removing the release layer 11, a process of separating the functional layer 14, the support layer 15 and the thin film holding layer 16 from the first substrate 10, and a process of transferring the functional layer 14, the support layer 15 and the thin film holding layer 16 to the second substrate 20.

In step S105 (FIG. 1), the release layer 11 is removed by means of etching as shown in FIG. 5(A). By this step, a gap G is formed between the functional layer 14 and the first substrate 10, more specifically, between the crystalline thin-film layer 12 and the first substrate 10.

The support layer 15 supports the functional layer 14 in the state of being separate from the first substrate 10. The support layer 15 inhibits force in a shear direction from acting on the functional layer 14, by which the cracking of the functional layer 14 is prevented.

In step S106 (FIG. 1), a third substrate 18 as a transfer member is joined to the thin film holding layer 16 as shown in FIG. 5(B). The third substrate 18 is formed of a hard material such as glass or silicon.

The third substrate 18 can be joined to the thin film holding layer 16 by using an adhesive sheet having a thermal release property or an ultraviolet release property, for example. It is also possible to directly join the third substrate 18 to the thin film holding layer 16 by forming the thin film holding layer 16 with a material having elasticity and adhesiveness (tackiness).

In step S107 (FIG. 1), as shown in FIG. 5(B), the support layer 15 is fractured by applying force to the third substrate 18 in a direction of separating from the first substrate 10. The support layer 15 fractures in the second part 152 being the thinnest, while the first part 151 remains on the first substrate 10. By this step, the functional layer 14, the support layer 15 (more specifically, the second part 152 and the third part 153) and the thin film holding layer 16 separate from the first substrate 10.

In step S108 (FIG. 1), as shown in FIG. 5(C), the functional layer 14 held by the thin film holding layer 16 joined to the third substrate 18 is joined to the second substrate 20.

On the front surface of the second substrate 20, each lower electrode 21 has been formed in a region larger than a prospective joint region for the functional layer 14. The lower electrode 21 is formed of a metal having high electrical conductivity such as platinum, gold, silver, aluminum or copper or an alloy including two or more of these metals. The lower electrode 21 has a thickness of 10 nm to 1000 nm.

The lower electrode 21 has a smooth surface in the prospective joint region for the functional layer 14, and surface roughness of the smooth surface is less than or equal to 10 nm, for example. The third substrate 18 and the second substrate 20 are positioned with each other by using alignment marks provided on the substrates.

Heating and pressing are executed in a state in which the functional layer 14 is in contact with the lower electrode 21 on the second substrate 20. Accordingly, the functional layer 14 is joined to the lower electrode 21 on the second substrate 20 by intermolecular force.

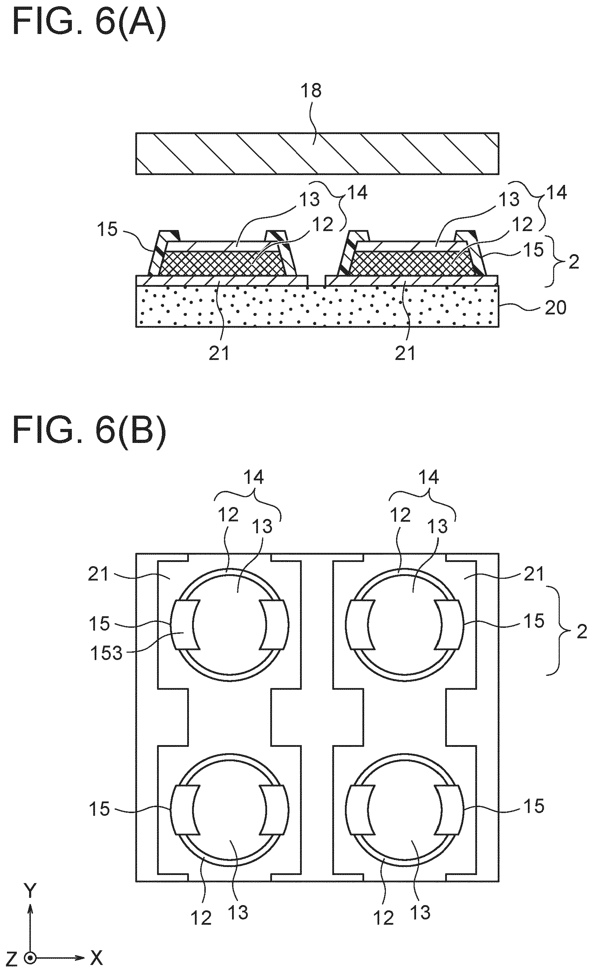

FIGS. 6(A) and 6(B) are a cross-sectional view and a plan view schematically showing a process of removing the thin film holding layer 16.

In step S109 (FIG. 1), the thin film holding layer 16 is removed as shown in FIG. 6(A). The thin film holding layer 16 can be removed by using a stripper solution, for example. Specifically, the unit (FIG. 5(C)) including the third substrate 18 and the second substrate 20 is placed in a bath storing the stripper solution and vibration is applied thereto. Consequently, the thin film holding layer 16 is dissolved and removed and the third substrate 18 peels off.

By the removal of the thin film holding layer 16, a configuration in which the crystalline thin-film layers 12 and the upper electrode layers 13 (i.e., the functional layers 14) are arrayed in a matrix on the lower electrodes 21 on the second substrate 20 is obtained as shown in FIG. 6(B). The lower electrodes 21 extend in a column direction (Y direction shown in FIG. 6(B)), and a plurality of crystalline thin-film layers 12 are arranged on each lower electrode 21. The lower electrodes 21 constitute longitudinal wirings of the second substrate 20.

By this step, piezoelectric elements 2 each including the crystalline thin-film layer 12, the upper electrode layer 13 and the lower electrode 21 are formed. Further, a piezoelectric device as an electronic device including the second substrate 20 and the piezoelectric elements 2 (each including the crystalline thin-film layer 12, the upper electrode layer 13 and the lower electrode 21) is obtained. By forming wirings and the like on this piezoelectric device, a piezoelectric module 200 which will be described next is obtained.

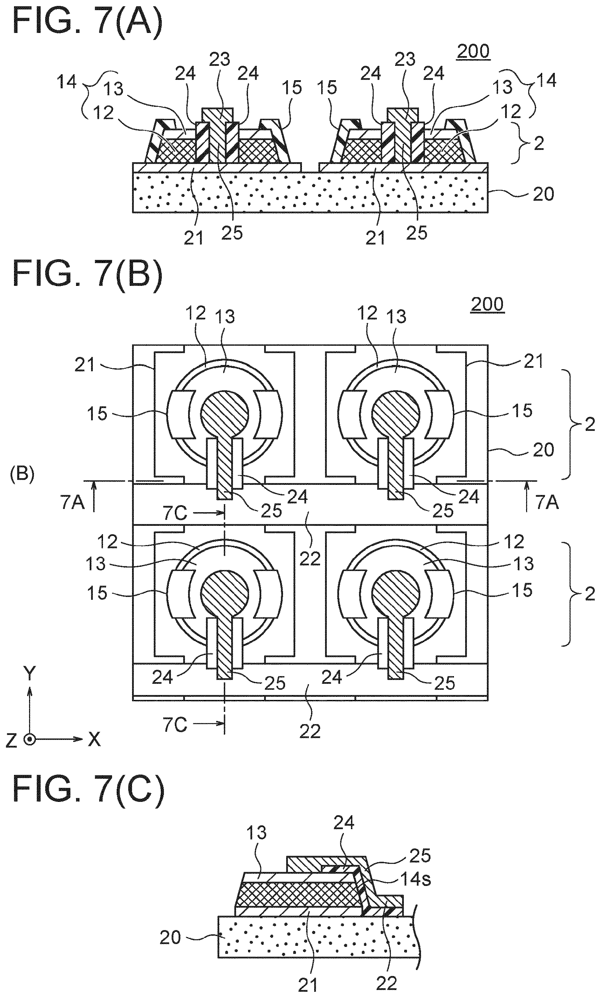

FIGS. 7(A) and 7(B) are a cross-sectional view and a plan view schematically showing a process of forming the wiring and the like on the second substrate 20. Incidentally, FIG. 7(A) corresponds to a cross-sectional view taken along the line segment 7A - 7A shown in FIG. 7(B). FIG. 7(C) is a cross-sectional view, which is different from FIG. 7(A), taken along the line segment 7C - 7C shown in FIG. 7(B).

In step S110 (FIG. 1), the wiring and the like are formed on the second substrate 20 as shown in FIGS. 7(A) and 7(B). As an example, an interlayer insulation layer 24 is formed between the upper electrode layer 13 and a transverse wiring 22 which will be described later. The interlayer insulation layer 24 extends from the front surface of the upper electrode layer 13 and along the side face of the crystalline thin-film layer 12. The transverse wiring 22 is a wiring layer extending in a row direction (X direction shown in FIG. 7(B)).

On the interlayer insulation layer 24, a lead wiring 25 extending from the front surface of the upper electrode layer 13 to the transverse wiring 22 is formed. Further, on the interlayer insulation layer 24, the aforementioned transverse wiring 22 is formed between adjoining crystalline thin-film layers 12. Incidentally, it is also possible to form the transverse wiring 22 and the lead wiring 25 in the same process.

Parenthetically, the support layer 15 may be either removed in a later process or used as an interlayer insulation layer of some type.

By the above processes, the piezoelectric module 200 including the second substrate 20, the piezoelectric elements 2 (each including the crystalline thin-film layer 12, the upper electrode layer 13 and the lower electrode 21), the transverse wirings 22, the lead wirings 25 and the like is formed.

### <Operation of Piezoelectric Module>

The transverse wirings 22 and the longitudinal wirings (lower electrodes) 21 on the second substrate 20 are connected to a not-shown driver. It is possible to drive an intended piezoelectric element 2 on the second substrate 20 by inputting a drive signal from the driver to the longitudinal wiring (lower electrode) 21 and the transverse wiring 22. Accordingly, the piezoelectric module 200 can be configured as an actuator such as MEMS (Micro Electro Mechanical Systems) or an ultrasonic generator.

It is also possible to configure the piezoelectric module 200 as a piezoelectric sensor, an ultrasonic sensor or the like by taking advantage of the phenomenon in which pressure applied to the piezoelectric element 2 causes potential difference between the upper electrode layer 13 and the lower electrode 21.

### <Function>

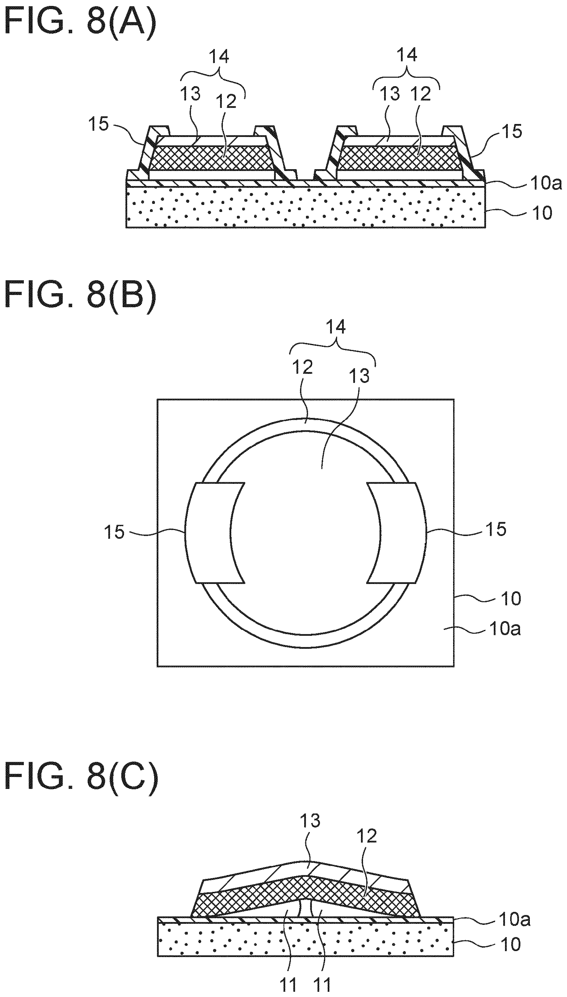

Next, the function of the first embodiment will be described below in comparison with a comparative example. FIGS. 8(A), 8(B) and 8(C) are a cross-sectional view, a plan view and a schematic diagram schematically showing a process of removing the release layer 11 in a manufacturing method of an electronic device in the comparative example. The manufacturing method of the electronic device in the comparative example differs from the manufacturing method of the electronic device in the first embodiment in that the removal of the release layer 11 is executed without using the thin film holding layer 16.

As shown in FIG. 8(A), in the process of removing the release layer 11, the support layer 15 supports the functional layer 14 in the state of being separate from the first substrate 10. Since the functional layer 14 (especially, the crystalline thin-film layer 12) is thin, it is difficult to support the functional layer 14 with the support layer 15 only. Thus, there is a possibility that the cracking occurs in a central part of the functional layer 14 or in the vicinity of a joint part between the functional layer 14 and the support layer 15 in the process of removing the release layer 11 or subsequent processes.

Further, as shown in FIGS. 8(B) and 8(C), there is also a possibility that an outer periphery of the functional layer 14 hangs down. In this case, there is a possibility of occurrence of an etching defect due to blockage of entry of the etching solution for removing the release layer 11, etching gas remaining under the crystalline thin-film layer 12, or the like.

Such cracking of the functional layer 14 and the etching defect become more likely to occur as the area of the functional layer 14 increases and become especially remarkable as the diameter of the functional layer 14 exceeds 1 mm.

In contrast, in the first embodiment, the thin film holding layer 16 is provided on the functional layer 14, and thus the shape of the functional layer 14 can be maintained during the process of removing the release layer 11 and subsequent processes. Accordingly, the cracking of the functional layer 14 can be prevented and the etching defect due to deformation of the functional layer 14 can be prevented.

Incidentally, while the thin film holding layer 16 covers the boundary part between the front surface 14f of the functional layer 14 and the support layer 15 in this example, this embodiment is not limited to such a configuration.

FIGS. 9(A) and 9(B) are a cross-sectional view and a plan view schematically showing another example of the process of removing the release layer 11. In the example shown in FIGS. 9(A) and 9(B), the third part 153 of the support layer 15 covers the top of the upper electrode layer 13. The thin film holding layer 16 is provided on the third part 153 of the support layer 15. Also in this case, the shape of the functional layer 14 is maintained by the thin film holding layer 16 and the support layer 15, by which the cracking and the deformation of the functional layer 14 can be prevented.

Incidentally, in the plan view of FIG. 9(B), the functional layer 14 (only the upper electrode layer 13 is shown in FIG. 9(B)) is in a quadrangular shape, the third part 153 of the support layer 15 (the part covering the upper electrode layer 13) is also in a quadrangular shape, and two first parts 151 extend from the third part 153 in each of a leftward direction and a rightward direction in the drawing. However, shapes of the elements in this example are not limited to those shown in FIG. 9(B). The functional layer 14 may be in a circular shape as shown in FIG. 3(B). Further, the number of first parts 151 in each support layer 15 may also be any desired number. It is also possible that the first parts 151 of two adjoining support layers 15 connect to each other.

Further, as shown in FIG. 9(C), the thin film holding layer 16 may be provided only on the front surface 14f of the functional layer 14 (the front surface of the upper electrode layer 13 in this case) without reaching the support layer 15. Namely, it is sufficient that the thin film holding layer 16 is formed on at least one of the support layer 15 and the front surface 14f of the functional layer 14.

In the above-described example, the functional layer 14 is formed on the first substrate 10 via the release layer 11 (steps S101 and S102) and thereafter the support layer 15 is formed (step S103). However, it is also possible to use the first substrate 10 on which the functional layer 14 has previously been formed via the release layer 11 and form the support layer 15 on the first substrate 10 from the front surface 14f of the functional layer 14 to the first substrate 10.

### <Effect of First Embodiment>

As described above, the manufacturing method of the electronic device in the first embodiment includes the process of forming the support layer 15 from the front surface (first surface) 14f of the functional layer 14 (which is formed on the first substrate 10 via the release layer 11) to the first substrate 10, the process of forming the thin film holding layer 16 on at least one of the support layer 15 and the front surface 14f of the functional layer 14, the process of removing the release layer 11 (first layer) after the thin film holding layer 16 is formed, the process of joining the third substrate (transfer member) 18 to the surface of the thin film holding layer 16 on the side opposite to the functional layer 14 after the first layer 11 is removed, the process of separating the functional layer 14, the support layer 15 and the thin film holding layer 16 from the first substrate 10, the process of transferring the functional layer 14, the support layer 15 and the thin film holding layer 16 to the second substrate 20, and the process of removing the thin film holding layer 16. Accordingly, the cracking of the functional layer 14 can be prevented, and the deformation of the functional layer 14 and the etching defect due to the deformation can be prevented. Consequently, the manufacturing yield can be increased.

Further, since the thickness of the thin film holding layer 16 is greater than the thickness of the functional layer 14, sufficient strength of the thin film holding layer 16 can be secured and the cracking or the like of the functional layer 14 can be prevented more effectively.

Since the area of the thin film holding layer 16 is smaller than the area of the front surface (first surface) 14f of the functional layer 14, the thin film holding layer 16 does not hang down along the side face 14s of the functional layer 14. Therefore, the etching defect caused by the blockage of the entry of the etching solution by the thin film holding layer 16 hanging down can be prevented.

Since the thin film holding layer 16 covers the boundary part between the front surface 14f of the functional layer 14 and the support layer 15, the cracking that is likely to occur in the boundary part can be prevented effectively.

Since the support layer 15 is formed in a region on the front surface 14f of the functional layer 14 other than the central region (element formation region or electrode formation region), the formation of the wiring in the subsequent process can be executed with ease.

The support layer 15 includes the first part 151 joined to the first substrate 10, the second part 152 joined to the side face 14s of the functional layer 14 and the third part 153 joined to the front surface 14f of the functional layer 14. The thickness T2 of the second part 152 is less than the thickness T1 of the first part 151 and less than the thickness T3 of the third part 153. Therefore, the support layer 15 can be surely fractured in the second part 152 at the time of peeling off the functional layer 14 from the first substrate 10.

### (Second Embodiment)

### <Manufacturing Method of Electronic Device>

An electronic device in a second embodiment is a photoelectric conversion device including a photoelectric conversion element such as an LED (Light-Emitting Diode), for example. The photoelectric conversion device is used for a photoelectric conversion module. The photoelectric conversion module is an LED display, an image sensor or the like, for example.

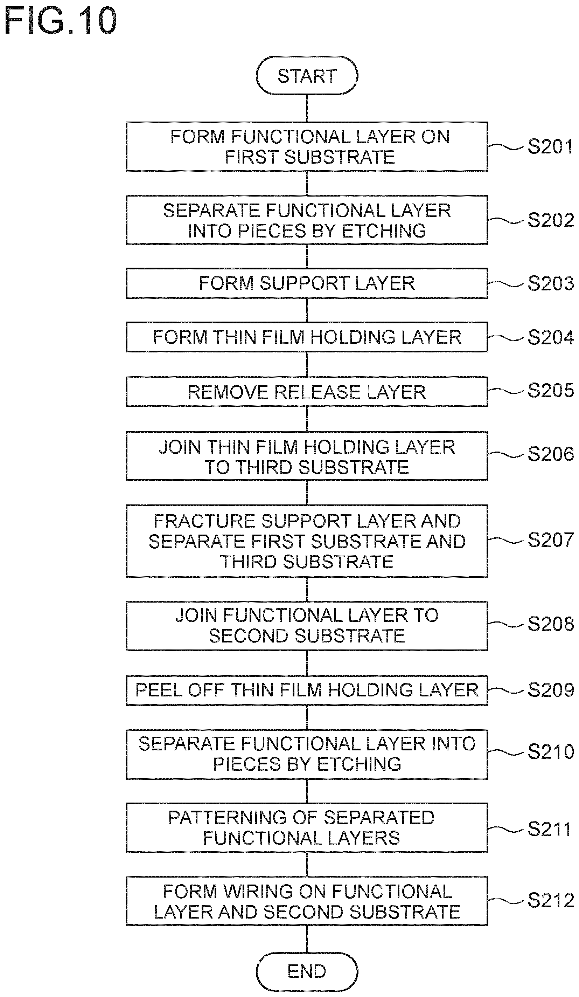

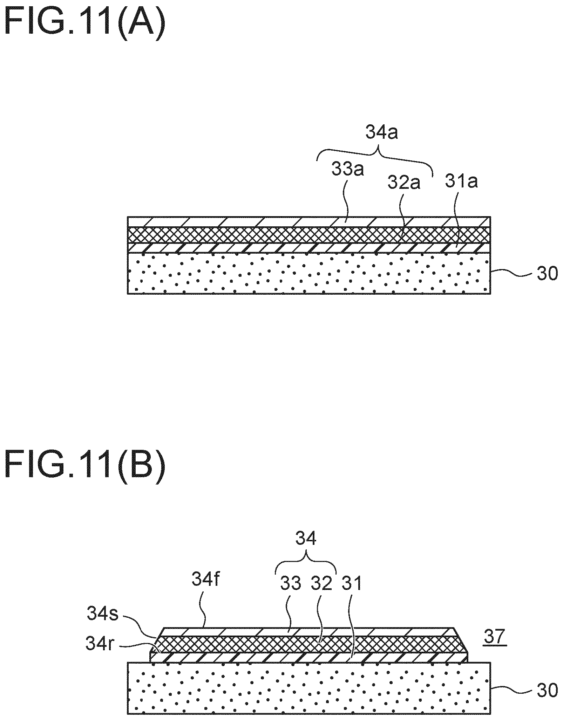

FIG. 10 is a flowchart showing a manufacturing method of an electronic device in the second embodiment. FIGS. 11(A) and 11(B) are cross-sectional views schematically showing a process of forming a release layer 31a and a functional layer 34a which will be described later on a first substrate 30 and a process of separating (singulating) the release layer 31a and the functional layer 34a by means of etching.

In step S201 (FIG. 10), as shown in FIG. 11(A), the release layer 31a, a crystalline thin-film layer 32a and a transparent electrode layer 33a are formed on the first substrate 30. Among these layers, the crystalline thin-film layer 32a and the transparent electrode layer 33a are referred to collectively as the functional layer 34a. Incidentally, the functional layer 34a may also be formed of the crystalline thin-film layer 32a alone.

The first substrate 30 is a growth substrate (wafer) on whose front surface the crystalline thin-film layer 32a is grown epitaxially. The first substrate 30 is formed of gallium arsenide, indium phosphide, silicon, sapphire or the like, for example. In cases where the first substrate 30 is formed of silicon or sapphire, it is desirable to form a buffer layer on the front surface of the substrate.

The crystalline thin-film layer 32a is a semiconductor layer having a light emitting property or a light receiving property. Specifically, the crystalline thin-film layer 32a can be a stacked body formed by stacking a group III-V compound semiconductor containing gallium, aluminum, indium, arsenic, nitrogen, phosphorus, or the like, a P-type semiconductor layer, an active layer, an etching stop layer, an N-type semiconductor layer, and the like. The thickness of the crystalline thin-film layer 32a is 500 nm to 10 µm, for example.

To obtain an excellent light emitting property, it is desirable to epitaxially grow the crystalline thin-film layer 32a on the first substrate 30 so as to form a single crystal having little lattice mismatch.

For the release layer 31a, it is desirable to select a material whose lattice constant is close to that of the crystalline thin-film layer 32a and whose etching selectivity is high, among materials such as aluminum arsenide, indium gallium arsenide, indium aluminum arsenide, and aluminum nitride, for example.

While the release layer 31a is a layer removed in a removal process which will be described later, the release layer 31a also plays a role of a buffer layer. It is also possible to form a buffer layer, which has a lattice constant between those of the first substrate 30 and the release layer 31a, on the front surface of the first substrate 30.

The transparent electrode layer 33a is formed of tin-doped indium oxide (ITO (Indium Tin Oxide)), fluorine-doped indium oxide, or the like. The transparent electrode layer 33a has transmittance higher than or equal to 70 % for the dominant wavelength used and has electrical conductivity. The thickness of the transparent electrode layer 33a is 10 nm to 1000 nm, for example. Incidentally, the formation of the transparent electrode layer 33a may also be executed after a transfer process onto a second substrate 40 which will be described later.

In the subsequent step S202 (FIG. 10), as shown in FIG. 11(B), grooves 37 are formed by means of photolithography or the like, by which the release layer 31a and the functional layer 34a are separated (singulated) into pieces like islands. In the second embodiment, the separation is carried out so that each island includes a plurality of element formation regions.

The release layer 31a after being separated is referred to as a "release layer 31". Similarly, the crystalline thin-film layer 32a after being separated is referred to as a "crystalline thin-film layer 32", and the transparent electrode layer 33a after being separated is referred to as a "transparent electrode layer 33". A functional layer 34 (referred to also as a "functional thin film") is formed by the crystalline thin-film layer 32 and the transparent electrode layer 33. Incidentally, the functional layer 34 may also be formed of the crystalline thin-film layer 32 alone.

Since the functional layer 34 includes a plurality of element formation regions, the functional layer 34 has a relatively large area of 1 mm to 20 mm, for example.

The functional layer 34 has a front surface (first surface) 34f on a side opposite to the first substrate 30, a back surface (second surface) 34r on a side facing the first substrate 30, and side faces 34s as inclined surfaces formed between the front surface 34f and the back surface 34r.

While the front surface of the transparent electrode layer 33 serves as the front surface 34f of the functional layer 34 in this example, the front surface of the crystalline thin-film layer 32 serves as the front surface 34f of the functional layer 34 when the functional layer 34 does not include the transparent electrode layer 33.

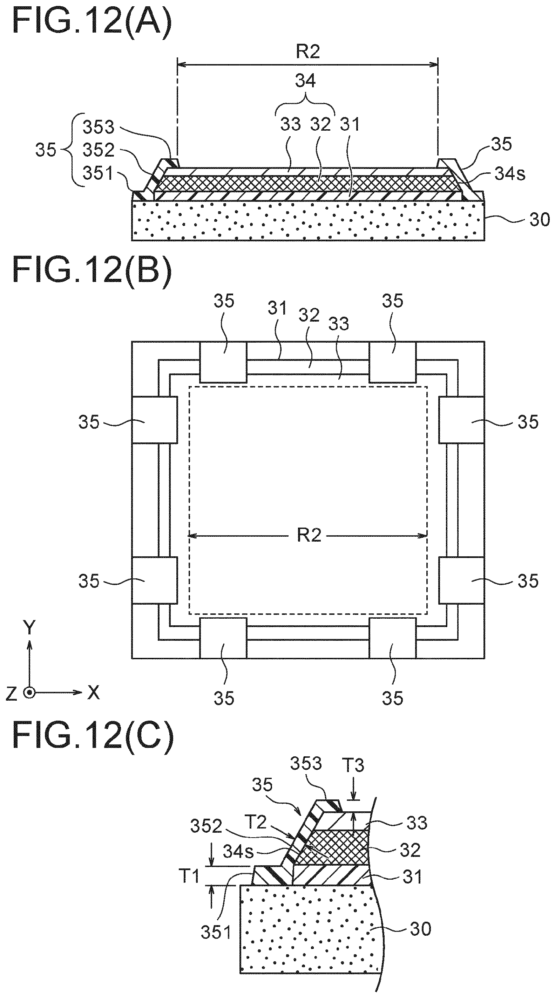

In this example, the two-dimensional shape (shape in a plane parallel to the front surface of the first substrate 30) of the functional layer 34 is a quadrangular shape (see FIG. 12(B)). However, the two-dimensional shape of the functional layer 34 is not limited to a quadrangular shape but may also be a circular shape, for example.

FIGS. 12(A) and 12(B) are a cross-sectional view and a plan view schematically showing a process of forming a support layer 35 which will be described below. In step S203 (FIG. 10), the support layer 35 is formed from the front surface 34f of the functional layer 34 to the front surface of the first substrate 30 as shown in FIG. 12(A). The support layer 35 is a part that supports the functional layer 34 with respect to the first substrate 30.

The support layer 35 is deposited by means of CVD (Chemical Vapor Deposition) or the like and thereafter patterned by means of lithography, etching or the like. The support layer 35 is formed of a material having resistance to the etching solution used in a process of removing the release layer 31 which will be described later. As an example, an inorganic insulation film such as an oxide film or a nitride film is desirable for the support layer 35.

The support layer 35 extends from the front surface of the transparent electrode layer 33 to the front surface of the first substrate 30 via a side face of the crystalline thin-film layer 32. In other words, the support layer 35 extends from the front surface 34f of the functional layer 34 to the front surface of the first substrate 30 via the side face 34s of the functional layer 34.

As shown in FIG. 12(B), the support layer 35 is provided at two positions on each of four sides of the functional layer 34 in the quadrangular shape. Namely, eight support layers 35 are provided for each functional layer 34.

A large proportion of the front surface of the first substrate 30, a large proportion of each of side faces of the release layer 31, the crystalline thin-film layer 32 and the transparent electrode layer 33, and a central region (represented by a reference character R2) of the front surface of the transparent electrode layer 33 are not covered by the support layer 35 and are exposed. The central region of the transparent electrode layer 33 is a region in which a wiring is formed in a subsequent process.

Incidentally, the number of support layers 35 for one functional layer 34 is not limited to 8. It is sufficient that one or more support layers 35 are provided for each functional layer 34.

FIG. 12(C) is a cross-sectional view schematically showing the cross-sectional shape of the support layer 35. The support layer 35 includes a first part 351 joined to the front surface of the first substrate 30, a second part 352 joined to the side face 34s of the functional layer 34, and a third part 353 joined to the front surface 34f of the functional layer 34.

The first part 351, the second part 352 and the third part 353 respectively have thicknesses T1, T2 and T3. The thickness T2 of the second part 352 is less than the thickness T1 of the first part 351 and less than the thickness T3 of the third part 353. In other words, the support layer 35 is configured so that the second part 352 is the most likely to be fractured.

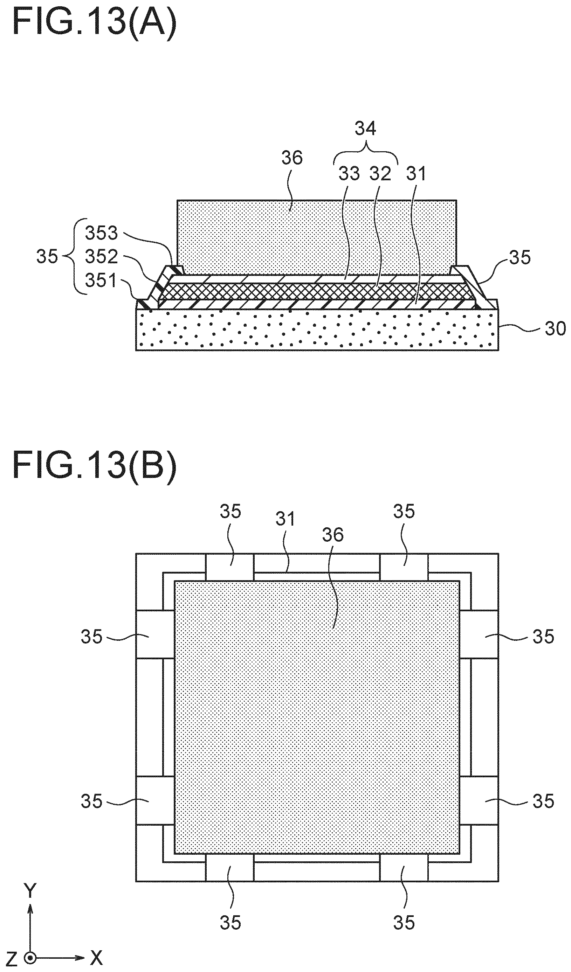

FIGS. 13(A) and 13(B) are a cross-sectional view and a plan view schematically showing a process of forming a thin film holding layer 36 which will be explained next. In step S204 (FIG. 10), the thin film holding layer 36 is formed on the functional layer 34 as shown in FIG. 13(A).

The thin film holding layer 36 is an organic structure and is formed of a material that has resistance to the etching solution used in the process of removing the release layer 31 which will be described later and that can be removed by using a stripper solution different from the etching solution. As an example, a photosensitive organic resist, silicone resin or the like is desirable for the thin film holding layer 36.

The thin film holding layer 36 is formed by depositing an organic resist or the like to cover the support layer 35 and the functional layer 34 on the first substrate 30 and patterning the deposited film by photolithography.

The thin film holding layer 36 is formed to be thicker than the functional layer 34, so that the thin film holding layer 36 has higher bending strength and shear strength than the functional layer 34. As an example, the thickness of the thin film holding layer 36 is 3 to 10 times the thickness of the functional layer 34.

Further, the linear expansion coefficient of the thin film holding layer 36 is desired to be less than the linear expansion coefficient of the crystalline thin-film layer 32 so that the crystalline thin-film layer 32 does not warp toward the first substrate 30 in the process of removing (etching) the release layer 31 which will be described later.

The thin film holding layer 36 is formed to cover a boundary part between the front surface 34f of the functional layer 34 (the front surface of the transparent electrode layer 33) and the support layer 35. With this configuration, the cracking that is likely to occur in the boundary part can be prevented effectively.

Further, the area of the thin film holding layer 36 is smaller than the area of the front surface 34f of the functional layer 34. Accordingly, the thin film holding layer 36 is prevented from hanging down toward the side face of the crystalline thin-film layer 32.

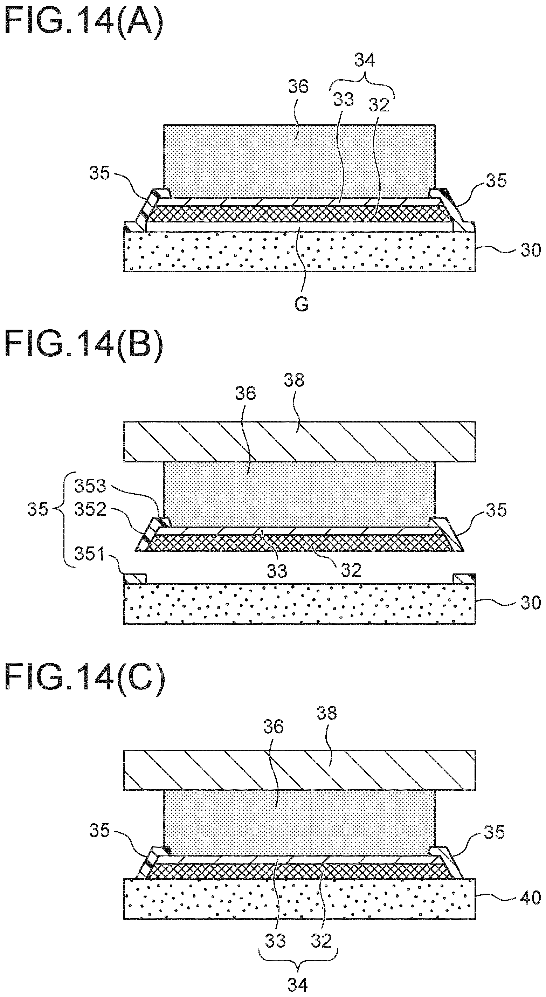

FIGS. 14(A), 14(B) and 14(C) are cross-sectional views schematically showing a process of removing the release layer 31, a process of separating the functional layer 34, the support layer 35 and the thin film holding layer 36 from the first substrate 30, and a process of transferring the functional layer 34, the support layer 35 and the thin film holding layer 36 to the second substrate 40.

In step S205 (FIG. 10), the release layer 31 is removed by means of etching. By this step, a gap G is formed between the functional layer 34 and the first substrate 30, more specifically, between the crystalline thin-film layer 32 and the first substrate 30.

The support layer 35 supports the functional layer 34 in the state of being separate from the first substrate 30. The support layer 35 inhibits force in the shear direction from acting on the functional layer 34, by which the cracking of the functional layer 34 is prevented.

In step S206 (FIG. 10), a third substrate 38 as the transfer member is joined to the thin film holding layer 36 as shown in FIG. 14(B). The third substrate 38 is formed of a hard material such as glass or silicon.

The third substrate 38 can be joined to the thin film holding layer 36 by using an adhesive sheet having the thermal release property or the ultraviolet release property, for example. It is also possible to directly join the third substrate 38 to the thin film holding layer 36 by forming the thin film holding layer 36 with a material having elasticity and adhesiveness (tackiness).

In step S207 (FIG. 10), as shown in FIG. 14(B), the support layer 35 is fractured by applying force to the third substrate 38 in the direction of separating from the first substrate 30. The support layer 35 fractures in the second part 352 being the thinnest, while the first part 351 remains on the first substrate 30. By this step, the functional layer 34, the support layer 35 (more specifically, the second part 352 and the third part 353) and the thin film holding layer 36 separate from the first substrate 30.

In step S208 (FIG. 10), as shown in FIG. 14(C), the functional layer 14 held by the thin film holding layer 36 joined to the third substrate 38 is joined to the second substrate 40.

The second substrate 40 has a smooth surface in the prospective joint region for the functional layer 34, and the surface roughness of the smooth surface is less than or equal to 10 nm, for example. The third substrate 38 and the second substrate 40 are positioned with each other by using alignment marks provided on the substrates.

Heating and pressing are executed in a state in which the functional layer 34 is in contact with the front surface of the second substrate 40. Accordingly, the functional layer 34 is joined to the front surface of the second substrate 40 by intermolecular force.

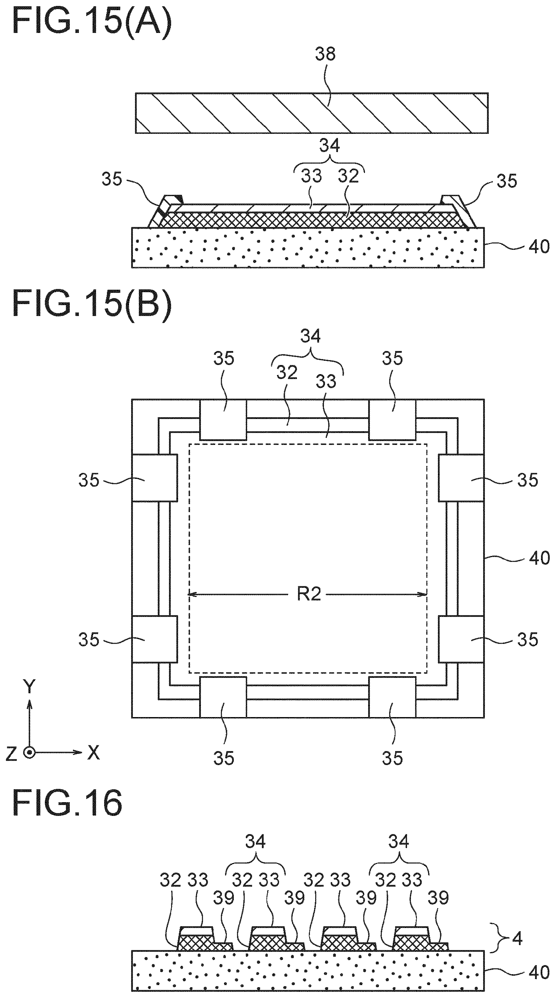

FIGS. 15(A) and 15(B) are a cross-sectional view and a plan view schematically showing a process of removing the thin film holding layer 36.

In step S209 (FIG. 10), the thin film holding layer 36 is removed as shown in FIG. 15(A). The thin film holding layer 36 can be removed by using a stripper solution, for example. Specifically, the unit (FIG. 14(C)) including the third substrate 38 and the second substrate 40 is placed in a bath storing the stripper solution and vibration is applied thereto. Consequently, the thin film holding layer 36 is dissolved and removed and the third substrate 38 peels off.

By the removal of the thin film holding layer 36, a configuration in which the crystalline thin-film layer 32 and the transparent electrode layer 33 are (i.e., the functional layer 34 is) provided on the second substrate 40 is obtained as shown in FIG. 15(B).

FIG. 16 is a cross-sectional view schematically showing a process of separating the functional layer 34 into pieces for respective elements. In step S210 (FIG. 10), as shown in FIG. 16, the P-type semiconductor layer of the crystalline thin-film layer 32 of the functional layer 34 is patterned by means of first stage etching. In this stage, the support layer 35 is removed. In other words, a part of the functional layer 34 and the support layer 35 are removed.

In the subsequent step S211, by means of second stage etching, the N-type semiconductor layer of the crystalline thin-film layer 32 of the functional layer 34 is patterned, by which cathode surfaces 39 are formed and the functional layer 34 is separated into a plurality of islands (i.e., element separation).

By this step, LED elements 4 each including the crystalline thin-film layer 32 and the transparent electrode layer 33 and patterned as an individual element are formed. Further, a photoelectric conversion device as an electronic device including the second substrate 40 and the LED elements 4 (including the crystalline thin-film layers 32 and the transparent electrode layers 33) is obtained. By forming the wirings and the like on the photoelectric conversion device, a photoelectric conversion module 300 which will be described next is obtained.

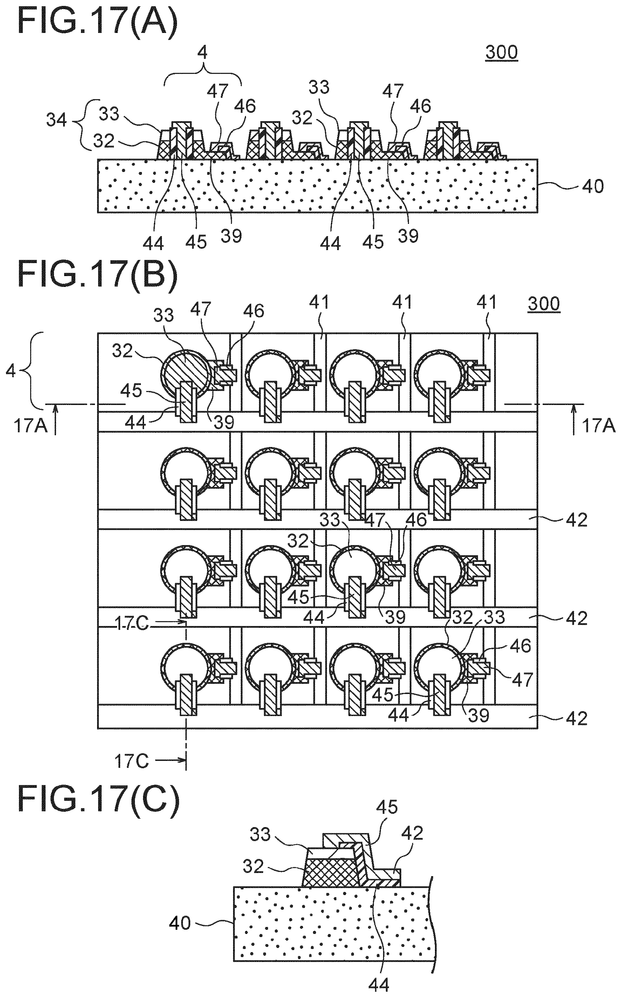

FIGS. 17(A) and 17(B) are a cross-sectional view and a plan view schematically showing a process of forming the wiring and the like on the functional layer 34 on the second substrate 40. Incidentally, FIG. 17(A) corresponds to a cross-sectional view taken along the line segment 17A - 17A shown in FIG. 17(B). Further, FIG. 17(C) is a cross-sectional view different from FIG. 17(A), as a cross-sectional view taken along the line segment 17C - 17C shown in FIG. 17(B).

In step S212 (FIG. 10), the wiring and the like are formed on the second substrate 40 as shown in FIGS. 17(A) and 17(B). As an example, a longitudinal wiring 41 extending in the column direction (Y direction in FIG. 17(B)) is formed on the front surface of the second substrate 40.

An interlayer insulation layer 46 is formed from the cathode surface 39 to the side face of the crystalline thin-film layer 32. On this interlayer insulation layer 46, a lead wiring 47 is formed so as to connect the cathode surface 39 and the longitudinal wiring 41.

Further, as shown in FIG. 17(C), an interlayer insulation layer 44 is formed so as to extend from the front surface of the transparent electrode layer 33 to the second substrate 40 via the side face of the crystalline thin-film layer 32. On this interlayer insulation layer 44, a transverse wiring 42 extending in the row direction (X direction in FIG. 17(B)) is formed between adjoining crystalline thin-film layers 32. Furthermore, a lead wiring 45 is formed so as to connect the transparent electrode layer 33 and the transverse wiring 42.

By the above-described processes, the photoelectric conversion module 300 including the second substrate 40, the LED elements 4 (including the crystalline thin-film layers 32 and the transparent electrode layers 33), the wirings 41 and 42, the lead wirings 45 and 47, and the like is formed.

### <Operation of Photoelectric Conversion Module>

The transverse wiring 42 and the longitudinal wiring 41 on the second substrate 40 are connected to a not-shown driver. It is possible to drive an intended LED element 4 on the second substrate 40 by inputting a drive signal from the driver to the longitudinal wiring 41 and the transverse wiring 42. Accordingly, the photoelectric conversion module 300 can be configured as an LED display, for example.

An LED array device can be employed as the light source of a liquid crystal display having a high dynamic range function by providing each LED element 4 with a current regulation circuit. Although an example in which the LED elements 4 are arrayed in a 4 × 4 matrix (4 rows by 4 columns) is shown in FIGS. 17(A) to 17(C) in order to clearly illustrate the configuration, a high-resolution micro-LED display can be formed by arraying the LED elements 4 in a 1280 × 720 matrix, for example.

Further, the second substrate 40 may be a silicon substrate or a thin-film transistor substrate, on which an active matrix CMOS (Complementary Metal Oxide Semiconductor) circuit is formed. In this case, a microdisplay can be produced by connecting active elements and electrodes on the second substrate 40.

Furthermore, while the LED element 4 in this example is a light-emitting element that emits light corresponding to applied voltage, the LED element 4 may also be used as a light-receiving element that outputs voltage corresponding to incident light. Namely, photoelectric conversion elements each including the LED element 4 can be configured as an image sensor, for example.

Incidentally, while the thin film holding layer 36 in this example covers the boundary part between the front surface 34f of the functional layer 34 and the support layer 35, it is sufficient that the thin film holding layer 36 is formed on at least one of the support layer 35 and the front surface 34f of the functional layer 34 as described in the first embodiment. Further, examples of the arrangement of the thin film holding layer 16 shown in FIGS. 9(A) to 9(C) in the first embodiment can be applied to the arrangement of the thin film holding layer 36 in the second embodiment.

In this example, the functional layer 34 is formed on the first substrate 30 via the release layer 31 (steps S201 and S202) and thereafter the support layer 35 is formed (step S203). However, it is also possible to use the first substrate 30 on which the functional layer 34 has previously been formed via the release layer 31 and form the support layer 35 on the first substrate 30 from the front surface 34f of the functional layer 34 to the first substrate 30.

### <Effect of Second Embodiment>

As described above, the manufacturing method of the electronic device in the second embodiment includes the process of forming the support layer 35 from the front surface (first surface) 14f of the functional layer 34 (which is formed on the first substrate 30 via the release layer 31) to the first substrate 30, the process of forming the thin film holding layer 36 on at least one of the support layer 35 and the front surface 34f of the functional layer 34, the process of removing the release layer 31 (first layer) after the thin film holding layer 36 is formed, the process of joining the third substrate (transfer member) 38 to the surface of the thin film holding layer 36 on the side opposite to the functional layer 34 after the first layer 31 is removed, the process of separating the functional layer 34, the support layer 35 and the thin film holding layer 36 from the first substrate 30, the process of transferring the functional layer 34, the support layer 35 and the thin film holding layer 36 to the second substrate 40, and the process of removing the thin film holding layer 36. Accordingly, the cracking of the functional layer 34 can be prevented, and the deformation of the functional layer 34 and the etching defect due to the deformation can be prevented. Consequently, the manufacturing yield can be increased.

Especially, in the manufacturing processes in which the functional layer 34 having a large area is peeled off from the first substrate 30 and transferred to the second substrate 40, the prevention of the cracking and deformation of the functional layer 34 has significant effect in improving the manufacturing yield. Further, since the transfer of the functional layer 34 having a large area becomes possible, it becomes possible to form a great number of LED elements 4 by separating the functional layer 34 into pieces by means of etching or the like.

Further, since the thickness of the thin film holding layer 36 is greater than the thickness of the functional layer 34, sufficient strength of the thin film holding layer 36 can be secured and the cracking or the like of the functional layer 34 can be prevented more effectively.

Since the area of the thin film holding layer 36 is smaller than the area of the front surface (first surface) 34f of the functional layer 34, the etching defect caused by the hanging down of the thin film holding layer 36 along the side face 34s of the functional layer 34 can be prevented.

Since the thin film holding layer 36 covers the boundary part between the front surface 34f of the functional layer 34 and the support layer 35, the cracking that is likely to occur in the boundary part can be prevented effectively.

Since the support layer 35 is formed in a region on the front surface 34f of the functional layer 34 other than the central region (element formation region or electrode formation region), the formation of the wiring in a subsequent process can be executed with ease.

The support layer 35 includes the first part 351 joined to the first substrate 30, the second part 352 joined to the side face 34s of the functional layer 34 and the third part 353 joined to the front surface 34f of the functional layer 34. The thickness T2 of the second part 352 is less than the thickness T1 of the first part 351 and less than the thickness T3 of the third part 353. Therefore, the support layer 35 can be surely fractured in the second part 352 at the time of peeling off the functional layer 34 from the first substrate 30.

### (Third Embodiment)

### <Manufacturing Method of Electronic Device>

An electronic device in a third embodiment is the piezoelectric device described in the first embodiment. However, the electronic device can also be the photoelectric conversion device described in the second embodiment. A manufacturing method of the electronic device in the third embodiment differs from that in the first embodiment is that functional layers 14 on the first substrate 10 are selectively peeled off (separated) and transferred.

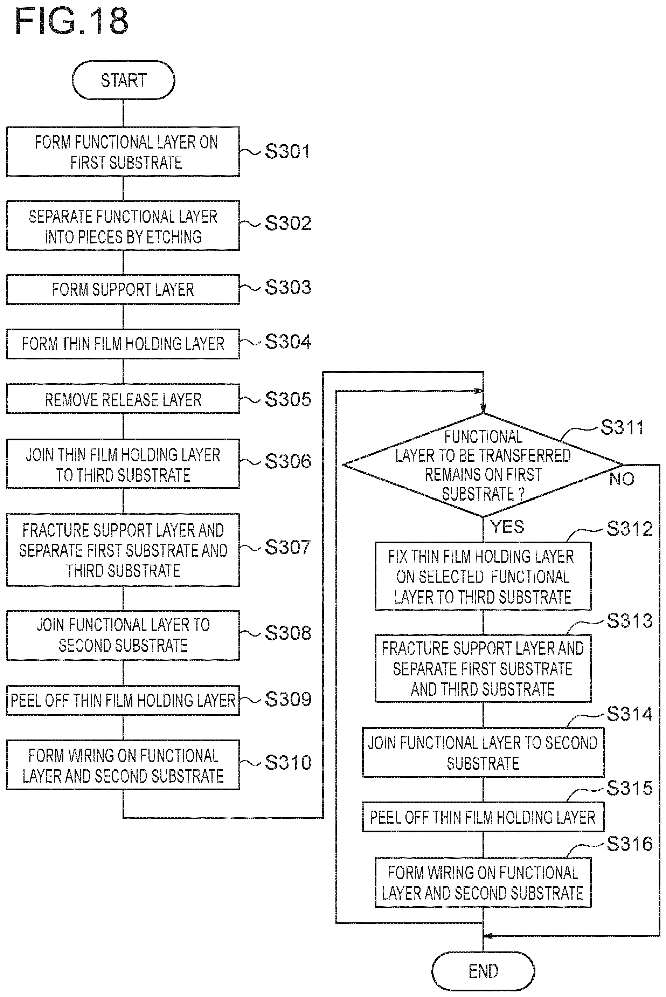

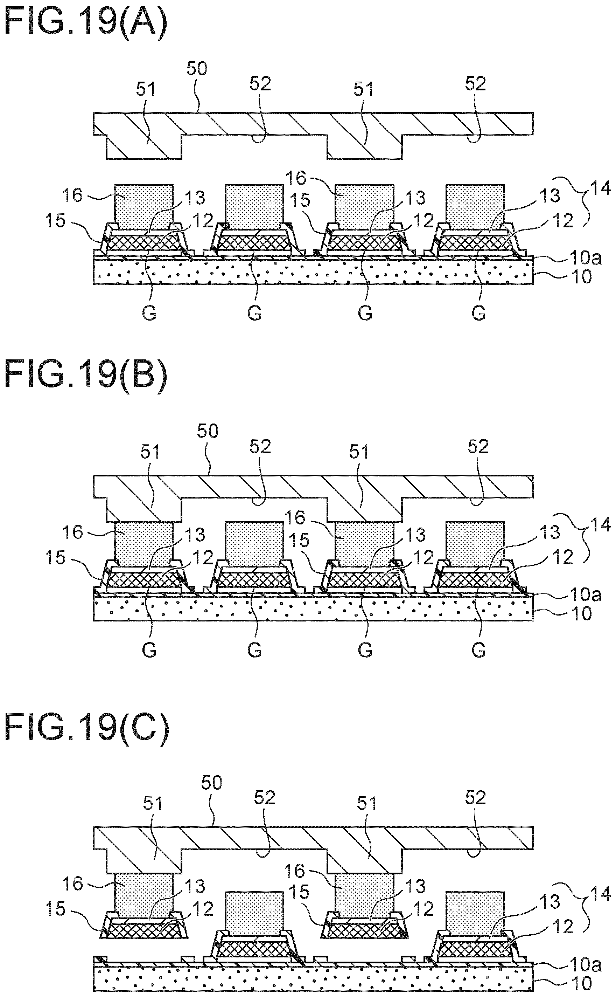

FIG. 18 is a flowchart showing the manufacturing method of the electronic device in the third embodiment. FIGS. 19(A), 19(B) and 19(C) are cross-sectional views schematically showing a process of removing the release layer 11, a process of joining a third substrate 50 to the thin film holding layer 16, and a process of peeling off the functional layer 14 from the first substrate 10.

Steps S301 to S305 (FIG. 18) are the same as the steps S101 to S105 (FIG. 1) in the first embodiment. Namely, as shown in FIG. 19(A), each functional layer 14 is supported by the support layer 15 in the state of being separate from the first substrate 10. Further, the thin film holding layer 16 is provided on the front surface 14f of the functional layer 14 and the support layer 15.

In step S306 (FIG. 18), the third substrate 50 having concaves and convexes is used as the transfer member. The third substrate 50 includes convex parts 51 projecting towards the first substrate 10. The interval between adjoining convex parts 51 of the third substrate 50 is wider than the interval between functional layers 14 adjoining each other on the first substrate 10.

In the example shown in FIG. 19(A), the convex parts 51 of the third substrate 50 respectively face the thin film holding layers 16 on alternate functional layers 14 on the first substrate 10. A concave part 52 is formed between adjoining convex parts 51 of the third substrate 50.

When the third substrate 50 is moved closer to the first substrate 10, each convex part 51 of the third substrate 50 is joined to a thin film holding layer 16 facing the convex part 51 among the thin film holding layers 16 on the functional layers 14 on the first substrate 10. The method of joining the third substrate 50 to the thin film holding layers 16 is as described in the first embodiment.

In step S307 (FIG. 18), force is applied to the third substrate 50 in the direction away from the first substrate 10 as shown in FIG. 19(C). The functional layers 14 under the thin film holding layers 16 joined to the convex parts 51 of the third substrate 50 are separated from the first substrate 10 by the fracture of the support layers 15.

On the other hand, the thin film holding layers 16 facing the concave parts 52 of the third substrate 50 and the functional layers 14 and the support layers 15 under such thin film holding layers 16 remain on the first substrate 10. Namely, selective peeling (i.e., pickup) of functional layers 14 is executed.

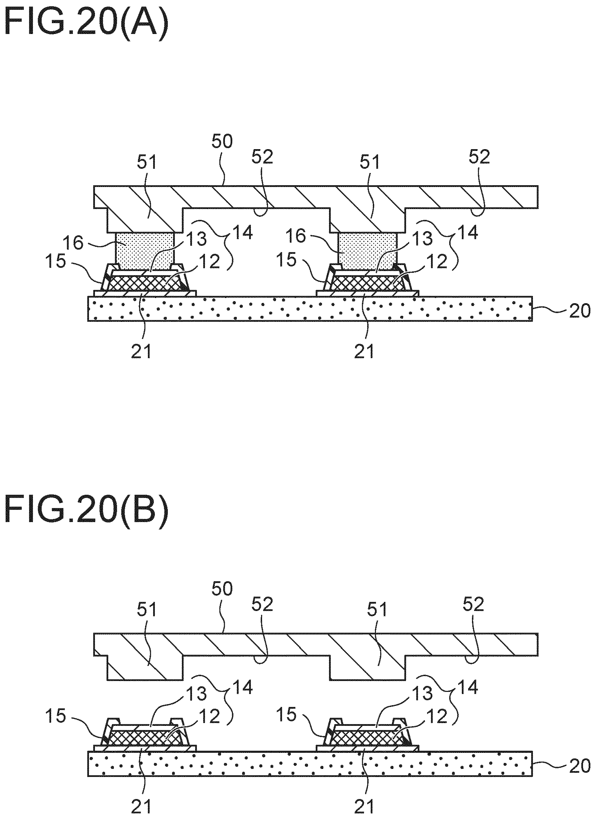

FIGS. 20(A) and 20(B) are cross-sectional views schematically showing a process of transferring the functional layer 14, the support layer 15 and the thin film holding layer 16 to the second substrate 20 and a process of removing the thin film holding layer 16.

In step S308 (FIG. 18), as shown in FIG. 20(A), the functional layer 14 held by the thin film holding layer 16 joined to the third substrate 18 is joined to the second substrate 20. On the front surface of the second substrate 20, the lower electrodes 21 described in the first embodiment have been formed. The functional layer 14 and the lower electrode 21 on the second substrate 20 are joined together by intermolecular force as described in the first embodiment.

In step S309 (FIG. 18), the thin film holding layer 16 is removed as shown in FIG. 20(B). The method of peeling off the thin film holding layer 16 is as described in the first embodiment.

In step S310 (FIG. 18), the lead wiring 45 and the like are formed on the functional layer 14 on the second substrate 20 similarly to the step S110 in the first embodiment. By this step, the piezoelectric elements 2 and a piezoelectric device including the piezoelectric elements 2 are formed. Further, by forming the wirings and the like on the second substrate 20, the piezoelectric module 200 (see FIG. 7(B) explained earlier) is formed.

In step S311 (FIG. 18), it is judged whether or not a functional layer 14 to be transferred remains on the first substrate 10. If no functional layer 14 to be transferred remains on the first substrate 10, the process is ended. If a functional layer 14 to be transferred remains on the first substrate 10, the process advances to step S312.

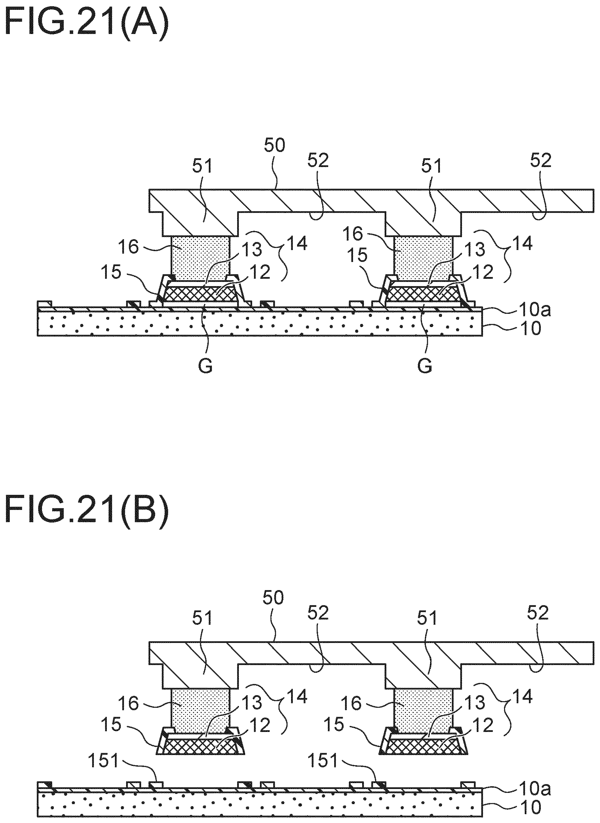

FIGS. 21(A) and 21(B) are cross-sectional views schematically showing a process of joining the third substrate 50 to the thin film holding layers 16 on the functional layers 14 remaining on the first substrate 10 and a process of peeling off the functional layers 14 from the first substrate 10.

In step S312 (FIG. 18), as shown in FIG. 21(A), the convex parts 51 of the third substrate 50 are placed to respectively face the thin film holding layers 16 on the functional layers 14 remaining on the first substrate 10, and the thin film holding layers 16 on the functional layers 14 and the convex parts 51 of the third substrate 50 are joined together. The method of joining the third substrate 50 and the thin film holding layers 16 is the same as the step S306.

Incidentally, in this step S312, the third substrate 50 used in the step S306 may be reused. In this case, the convex parts 51 can be joined to the thin film holding layers 16 on the functional layers 14 other than those in the step S306 by shifting the alignment position of the third substrate 50 with respect to the first substrate 10.

In step S313 (FIG. 18), as shown in FIG. 21(B), force is applied to the third substrate 50 in the direction away from the first substrate 10. The functional layers 14 under the thin film holding layers 16 joined to the convex parts 51 of the third substrate 50 are separated from the first substrate 10 by the fracture of the support layers 15.

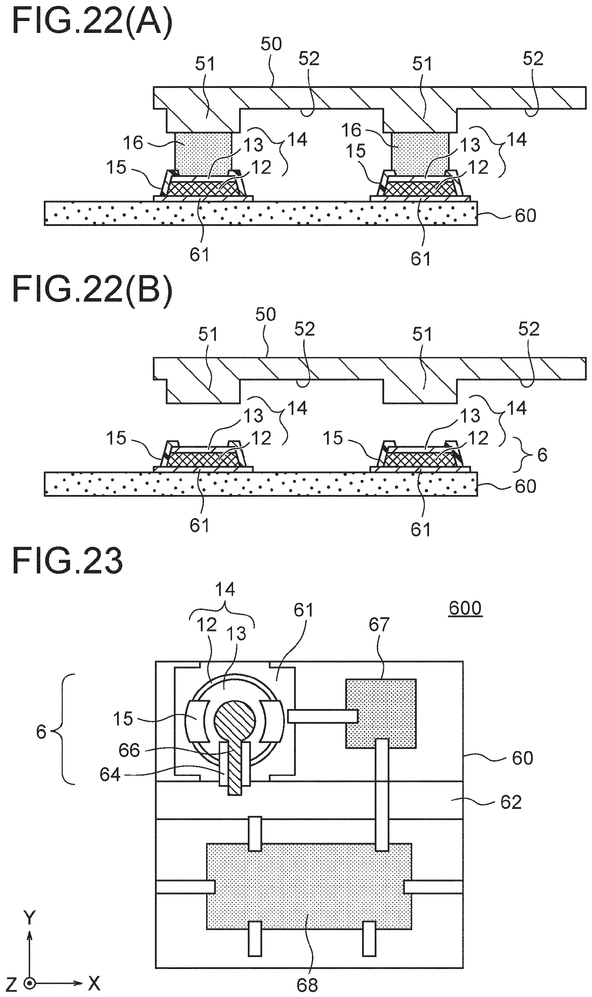

FIGS. 22(A) and 22(B) are cross-sectional views schematically showing a process of transferring the functional layer 14, the support layer 15 and the thin film holding layer 16 to a second substrate 60 and a process of removing the thin film holding layer 16.

In step S314 (FIG. 18), as shown in FIG. 22(A), the functional layer 14 held by the thin film holding layer 16 joined to the third substrate 50 is joined to a different second substrate 60. While the second substrate 60 is a substrate different from the second substrate 20, the second substrate 60 is configured in the same way as the second substrate 20.

On the front surface of the second substrate 60, lower electrodes 61 which are the same as the lower electrodes 21 on the second substrate 20 have been formed. The functional layer 14 and the lower electrode 61 on the second substrate 60 are joined together by intermolecular force as described in the first embodiment.

In step S315 (FIG. 18), the thin film holding layer 16 is removed as shown in FIG. 22(B). The method of peeling off the thin film holding layer 16 is as described in the first embodiment.

By this step, piezoelectric elements 6 each including the crystalline thin-film layer 12, the upper electrode layer 13 and the lower electrode 61 are formed. Further, a piezoelectric device as an electronic device including the second substrate 60, the crystalline thin-film layers 12, the upper electrode layers 13 and the lower electrodes 61 is obtained. By providing this piezoelectric device with the wirings and the like, a piezoelectric module 600 which will be described next is obtained.

In step S316 (FIG. 18), a lead wiring 66 and the like are formed on the second substrate 60 similarly to the step S310 described earlier.

FIG. 23 is a plan view schematically showing a process of forming wirings and the like on the second substrate 60. An interlayer insulation layer 64 extending along the side face of the crystalline thin-film layer 12 from the front surface of the upper electrode layer 13 is formed between the upper electrode layer 13 and transverse wiring 62 which will be described below. The transverse wiring 62 is a wiring layer extending in the row direction (X direction in FIG. 23). On the interlayer insulation layer 64, the lead wiring 66 extending from the front surface of the upper electrode layer 13 to the transverse wiring 62 is formed.

By the above-described processes, the piezoelectric module 600 including the second substrate 60, the piezoelectric elements 6 (each including the crystalline thin-film layer 12, the upper electrode layer 13 and the lower electrode 61), the transverse wirings 62, the lead wirings 66 and the like is formed.

Further, as shown in FIG. 23, it is also possible to further mount a sensor 67, a micro-IC (Integrated Circuit) 68 and the like, for example, on the second substrate 60 and connect these components to the transverse wiring 62. The sensor 67 and the micro-IC 68 can be mounted by flip-chip bonding. Alternatively, in cases where the sensor 67 and the micro-IC 68 are formed of crystalline thin films, it is also possible to grow the sensor 67 and the micro-IC 68 on a growth substrate similarly to the aforementioned crystalline thin-film layer 12 and join the sensor 67 and the micro-IC 68 to the second substrate 60.

Incidentally, while the case where the selective peeling (pickup) of functional layers 14 from the first substrate 10 and the joining of the functional layers 14 to a different substrate are executed twice has been described here, the selective peeling (pickup) and the joining may be executed three times or more. Further, examples of the arrangement of the thin film holding layer 16 shown in FIGS. 9(A) to 9(C) in the first embodiment can be applied to the arrangement of the thin film holding layer 16 in the third embodiment.

Except for the above-described features, the manufacturing method of the electronic device in the third embodiment is the same as the manufacturing method of the electronic device in the first embodiment.

### <Effect of Third Embodiment>

As described above, in the third embodiment, by using the third substrate 50 as the transfer member having a concave/convex shape, the functional layers 14 on the first substrate 10 are selectively peeled off and transferred to the second substrate 20. Therefore, it is possible to form the functional layers 14 at high density on the first substrate 10 and transfer the functional layers 14 to a different substrate (the second substrate 20, the second substrate 60 or the like) at an arrangement pitch adapted to the purpose. Accordingly, wasting of expensive crystalline thin-film layers 12 can be eliminated and the manufacturing cost can be reduced.

Further, since the thin film holding layers 16 have previously been formed on all of the functional layers 14 on the first substrate 10 and all of the release layers 11 on the first substrate 10 have been removed, it is unnecessary to execute the formation of the thin film holding layer 16 and the removal of the release layer 11 upon each pickup. Therefore, the manufacturing process can be shortened.

While the description in the above first to third embodiments has been given of the piezoelectric device and the photoelectric conversion device as examples of the electronic device, the first to third embodiments are not limited to manufacturing methods of the piezoelectric device and the photoelectric conversion device but are applicable to manufacturing methods of various types of electronic devices including switching elements, power devices and the like, for example.

While preferred embodiments have been described specifically above, the present disclosure is not limited to the above-described embodiments and a variety of improvement or modification is possible.

The present invention is applicable to manufacturing methods of electronic devices such as piezoelectric devices, photoelectric conversion devices, switching elements and power devices.

### DESCRIPTION OF REFERENCE CHARACTERS

2, 6: piezoelectric element, 4: LED element, 6: piezoelectric element, 10: first substrate, 10a: buffer layer, 11: release layer, 12: crystalline thin-film layer, 13: upper electrode layer, 14: functional layer, 14f: front surface, 14r: back surface, 14s: side face, 15: support layer, 16: thin film holding layer, 17: groove, 18: third substrate (transfer member), 20: second substrate, 21: lower electrode, 22: transverse wiring, 24: interlayer insulation layer, 25: lead wiring, 30: first substrate, 31: release layer, 32: crystalline thin-film layer, 33: transparent electrode layer, 33a: transparent electrode layer, 34: functional layer, 34a: functional layer, 34f: front surface, 34r: back surface, 34s: side face, 35: support layer, 36: thin film holding layer, 37: groove, 38: third substrate (transfer member), 40: second substrate, 41: longitudinal wiring, 42: transverse wiring, 45: lead wiring, 47: lead wiring, 50: third substrate, 51: convex part, 52: concave part, 60: second substrate, 61: lower electrode, 62: transverse wiring, 66: lead wiring, 151: first part, 152: second part, 153: third part, 200, 600: piezoelectric module, 300: photoelectric conversion module, 351: first part, 352: second part, 353: third part

## Claims

1. A manufacturing method of an electronic device, comprising:
a process of forming a support layer (15, 35) that is provided to extend from a first surface (14f, 34f) of a functional layer (14, 34) formed on a first substrate (10, 30) via a first layer (11, 31), as a surface on a side opposite to the first substrate (10, 30), to the first substrate (10, 30) and supports the functional layer (14, 34) with respect to the first substrate (10, 30);
a process of forming a thin film holding layer (16, 36) on at least one of the support layer (15, 35) and the first surface (14f, 34f) of the functional layer (14, 34);
a process of removing the first layer (11, 31) after the thin film holding layer (16, 36) is formed;
a process of joining a transfer member (18, 38, 50) to a surface of the thin film holding layer (16, 36) on a side opposite to the functional layer (14, 34) after the first layer (11, 31) is removed;
a process of separating the functional layer (14, 34), the support layer (15, 35) and the thin film holding layer (16, 36) from the first substrate (10, 30);
a process of transferring the functional layer (14, 34), the support layer (15, 35) and the thin film holding layer (16, 36) to a second substrate (20, 40, 60) different from the first substrate (10, 30); and
a process of removing the thin film holding layer (16, 36).

2. The manufacturing method of an electronic device according to claim 1, wherein thickness of the thin film holding layer (16, 36) is greater than thickness of the functional layer (14, 34).

3. The manufacturing method of an electronic device according to claim 1 or 2, wherein shear strength of the thin film holding layer (16, 36) is higher than shear strength of the functional layer (14, 34).

4. The manufacturing method of an electronic device according to any one of claims 1 to 3, wherein an area of the thin film holding layer (16, 36) in a plane parallel to the first surface (14f, 34f) is smaller than an area of the first surface (14f, 34f) of the functional layer (14, 34).

5. The manufacturing method of an electronic device according to any one of claims 1 to 4, wherein the thin film holding layer (16, 36) is formed to cover a boundary part between the first surface (14f, 34f) of the functional layer (14, 34) and the support layer (15, 35) in the process of forming the thin film holding layer (16, 36).

6. The manufacturing method of an electronic device according to any one of claims 1 to 5, wherein the support layer (15, 35) is formed in a region (R1, R2) on the first surface (14f, 34f) of the functional layer (14, 34) other than a central region in the process of forming the support layer (15, 35).

7. The manufacturing method of an electronic device according to any one of claims 1 to 6, wherein the support layer (15, 35) includes a first part (151, 351) joined to the first substrate (10, 30), a second part (152, 352) joined to a side face of the functional layer (14, 34), and a third part (153, 353) joined to the first surface (14f, 34f) of the functional layer (14, 34), and
wherein thickness of the second part (152, 352) is less than thickness of the first part (151, 351) and less than thickness of the third part (153, 353).

8. The manufacturing method of an electronic device according to any one of claims 1 to 7, comprising a process of removing the support layer (15, 35) and a part of the functional layer (14, 34) after the process of removing the thin film holding layer (16, 36).

9. The manufacturing method of an electronic device according to any one of claims 1 to 8, wherein in the process of joining the transfer member (18, 38, 50), the transfer member (18, 38, 50) having concaves and convexes on a side facing the thin film holding layer (16, 36) is used, and
wherein the transfer member (18, 38, 50) is selectively joined to the thin film holding layer (16, 36) on each of one or more functional layers (14, 34) among a plurality of functional layers (14, 34) on the first substrate (10, 30).

10. The manufacturing method of an electronic device according to claim 9, wherein the thin film holding layer (16, 36) is formed on every functional layer (14, 34) on the first substrate (10, 30) in the process of forming the thin film holding layer (16, 36), and
wherein the first layer (11, 31) under every functional layer (14, 34) on the first substrate (10, 30) is removed in the process of removing the first layer (11, 31).

11. The manufacturing method of an electronic device according to any one of claims 1 to 10, wherein the electronic device is a piezoelectric device.

12. The manufacturing method of an electronic device according to any one of claims 1 to 10, wherein the electronic device is a photoelectric conversion device.

## Patentansprüche

1. Verfahren zur Herstellung einer elektronischen Vorrichtung, umfassend:
einen Prozess des Bildens einer Trägerschicht (15, 35), die derart bereitgestellt wird, dass sie sich von einer ersten Oberfläche (14f, 34f) einer funktionalen Schicht (14, 34), gebildet auf einer ersten Oberfläche (10, 30) über eine erste Schicht (11, 31), als eine Oberfläche auf einer Seite entgegengesetzt zu dem ersten Substrat (10, 30) bis zu dem ersten Substrat (10, 30) erstreckt und die funktionale Schicht (14, 34) hinsichtlich des ersten Substrats (10, 30) trägt;
einen Prozess des Bildens einer Dünnfilmhalteschicht (16, 36) auf wenigstens einer von der Trägerschicht (15, 35) und der ersten Oberfläche (14f, 34f) der funktionalen Schicht (14, 34);
einen Prozess des Entfernens der ersten Schicht (11, 31), nachdem die Dünnfilmhalteschicht (16, 36) gebildet ist;
einen Prozess des Verbindens eines Transferbauteils (18, 38, 50) mit einer Oberfläche des Dünnfilmhalteschicht (16, 36) auf einer Seite entgegengesetzt zu der funktionalen Schicht (14, 34), nachdem die erste Schicht (11, 31) entfernt ist;
einen Prozess des Separierens der funktionalen Schicht (14, 34), der Trägerschicht (15, 35) und der Dünnfilmhalteschicht (16, 36) von dem ersten Substrat (10, 30);
einen Prozess des Transferierens der funktionalen Schicht (14, 34), der Trägerschicht (15, 35) und der Dünnfilmhalteschicht (16, 36) auf ein zweites Substrat (20, 40, 60), das von dem ersten Substrat (10, 30) verschieden ist; und
einen Prozess des Entfernens der Dünnfilmhalteschicht (16, 36).

2. Verfahren zur Herstellung einer elektronischen Vorrichtung nach Anspruch 1, wobei eine Dicke der Dünnfilmhalteschicht (16, 36) größer ist als eine Dicke der funktionalen Schicht (14, 34).

3. Verfahren zur Herstellung einer elektronischen Vorrichtung nach einem der Ansprüche 1 oder 2, wobei eine Scherfestigkeit der Dünnfilmhalteschicht (16, 36) höher ist als eine Scherfestigkeit der funktionalen Schicht (14, 34).

4. Verfahren zur Herstellung einer elektronischen Vorrichtung nach einem der Ansprüche 1 bis 3, wobei eine Fläche der Dünnfilmhalteschicht (16, 36) in einer Ebene parallel zu der ersten Oberfläche (14f, 34f) kleiner ist als eine Fläche der ersten Oberfläche (14f, 34f) der funktionalen Schicht (14, 34).

5. Verfahren zur Herstellung einer elektronischen Vorrichtung nach einem der Ansprüche 1 bis 4, wobei die Dünnfilmhalteschicht (16, 36) in dem Prozess des Bildens der Dünnfilmhalteschicht (16, 36) derart gebildet wird, dass sie einen Grenzteil zwischen der ersten Oberfläche (14f, 34f) der funktionalen Schicht (14, 34) und der Trägerschicht (15, 35) bedeckt.

6. Verfahren zur Herstellung einer elektronischen Vorrichtung nach einem der Ansprüche 1 bis 5, wobei die Trägerschicht (15, 35) in dem Prozess des Bildens der Trägerschicht (15, 35) in einer anderen Region (R1, R2) auf der ersten Oberfläche (14f, 34f) der funktionalen Schicht (14, 34) als einer zentralen Region gebildet wird.

7. Verfahren zur Herstellung einer elektronischen Vorrichtung nach einem der Ansprüche 1 bis 6, wobei die Trägerschicht (15, 35) einen ersten Teil (151, 351) umfasst, der mit dem ersten Substrat (10, 30) verbunden ist, einen zweiten Teil (152, 352), der mit einer Seitenfläche der funktionalen Schicht (14, 34) verbunden ist, und einen dritten Teil (153, 353), der mit der ersten Oberfläche (14f, 34f) der funktionalen Schicht (14, 34) verbunden ist, und
wobei eine Dicke des zweiten Teils (152, 352) geringer ist als eine Dicke des ersten Teils (151, 351) und geringer als eine Dicke des dritten Teils (153, 353).

8. Verfahren zur Herstellung einer elektronischen Vorrichtung nach einem der Ansprüche 1 bis 7, umfassend einen Prozess des Entfernens der Trägerschicht (15, 35) und eines Teils der funktionalen Schicht (14, 34) nach dem Prozess des Entfernens des Dünnfilmhalteschicht (16, 36).

9. Verfahren zur Herstellung einer elektronischen Vorrichtung nach einem der Ansprüche 1 bis 8, wobei in dem Prozess des Verbindens des Transferbauteils (18, 38, 50) das Transferbauteil (18, 38, 50) verwendet wird, das konkave und konvexe Bereiche auf einer Seite hat, die der Dünnfilmhalteschicht (16, 36) zugewandt ist, und
wobei das Transferbauteil (18, 38, 50) selektiv mit der Dünnfilmhalteschicht (16, 36) auf jeder von einer oder mehr funktionalen Schichten (14, 34) aus einer Mehrzahl von funktionalen Schichten (14, 34) auf der ersten Oberfläche (10, 30) verbunden wird.

10. Verfahren zu Herstellung einer elektronischen Vorrichtung nach Anspruch 9, wobei die Dünnfilmhalteschicht (16, 36) in dem Prozess des Bildens der Dünnfilmhalteschicht (16, 36) auf jeder funktionalen Schicht (14, 34) auf dem ersten Substrat (10, 30) gebildet wird, und
wobei die erste Schicht (11, 31) in dem Prozess des Entfernens der ersten Schicht (11, 31) unter jeder funktionalen Schicht (14, 34) auf der ersten Oberfläche (10, 30) entfernt wird.

11. Verfahren zur Herstellung einer elektronischen Vorrichtung nach einem der Ansprüche 1 bis 10, wobei die elektronische Vorrichtung eine piezoelektrische Vorrichtung ist.

12. Verfahren zur Herstellung einer elektronischen Vorrichtung nach einem der Ansprüche 1 bis 10, wobei die elektronische Vorrichtung eine fotoelektrische Umwandlungsvorrichtung ist.

## Revendications

1. Un procédé de fabrication d'un dispositif électronique, comprenant :
un processus de formation d'une couche de support (15, 35) qui est prévue pour s'étendre depuis une première surface (14f, 34f) d'une couche fonctionnelle (14, 34) formée sur un premier substrat (10, 30), via une première couche (11, 31) en tant que surface sur un côté opposé au premier substrat (10, 30), jusqu'au premier substrat (10, 30), et qui supporte la couche fonctionnelle (14, 34) par rapport au premier substrat (10, 30) ;
un processus de formation d'une couche (16, 36) de maintien de film mince sur au moins une parmi la couche de support (15, 35) et la première surface (14f, 34f) de la couche fonctionnelle (14, 34) ;
un processus d'élimination de la première couche (11, 31) après que la couche (16, 36) de maintien de film mince ait été formée ;
un processus de jonction d'un élément de transfert (18, 38, 50) à la surface de la couche (16, 36) de maintien de film mince sur un côté opposé à la couche fonctionnelle (14, 34) après que la première couche (11, 31) ait été retirée ;
un processus de séparation de la couche fonctionnelle (14, 34), de la couche de support (15, 35) et de la couche (16, 36) de maintien de film mince, d'avec le premier substrat (10, 30) ;
un processus de transfert de la couche fonctionnelle (14, 34), de la couche de support (15, 35) et de la couche (16, 36) de maintien de film mince vers un deuxième substrat différent du premier substrat (10, 30) ; et
un processus d'élimination de la couche (16, 36) de maintien de film mince.

2. Le procédé de fabrication d'un dispositif électronique selon la revendication 1, dans lequel l'épaisseur de la couche (16, 36) de maintien de film mince est supérieure à l'épaisseur de la couche fonctionnelle (14, 34).

3. Le procédé de fabrication d'un dispositif électronique selon la revendication 1 ou la revendication 2, dans lequel la résistance au cisaillement de la couche (16, 36) de maintien de film mince est supérieure à la résistance au cisaillement de la couche fonctionnelle (14, 34).

4. Le procédé de fabrication d'un dispositif électronique selon l'une quelconque des revendications 1 à 3, dans lequel une zone de la couche (16, 36) de maintien de film mince dans un plan parallèle à la première surface (14f, 34f) est plus petite qu'une zone de la première surface (14f, 34f) de la couche fonctionnelle (14, 34).

5. Le procédé de fabrication d'un dispositif électronique selon l'une quelconque des revendications 1 à 4, dans lequel la couche (16, 36) de maintien de film mince est formée de manière à recouvrir une partie de limite entre la première surface (14f, 34f) de la couche fonctionnelle (14, 34) et la couche de support (15, 35) dans le processus de formation de la couche (16, 36) de maintien de film mince.

6. Le procédé de fabrication d'un dispositif électronique selon l'une quelconque des revendications 1 à 5, dans lequel la couche de support (15, 35) est formée dans une zone (R1, R2) sur la première surface (14f, 34f) de la couche fonctionnelle (14, 34) autre qu'une zone centrale dans le processus de formation de la couche de support (15, 35).

7. Le procédé de fabrication d'un dispositif électronique selon l'une quelconque des revendications 1 à 6, dans lequel la couche de support (15, 35) comprend une première partie (151, 351) reliée au premier substrat (10, 30), une deuxième partie (152, 352) reliée à une face latérale de la couche fonctionnelle (14, 34), et une troisième partie (153, 353) reliée à la première surface (14f, 34f) de la couche fonctionnelle (14, 34), et
dans lequel l'épaisseur de la deuxième partie (152, 352) est inférieure à l'épaisseur de la première partie (151, 351) et inférieure à l'épaisseur de la troisième partie (153, 353).

8. Le procédé de fabrication d'un dispositif électronique selon l'une quelconque des revendications 1 à 7, comprenant un processus d'élimination de la couche de support (15, 35) et d'une partie de la couche fonctionnelle (14, 34) après le processus d'élimination de la couche (16, 36) de maintien de film mince.

9. Le procédé de fabrication d'un dispositif électronique selon l'une quelconque des revendications 1 à 8, dans lequel, dans le processus de jonction de l'élément de transfert (18, 38, 50), on utilise l'élément de transfert (18, 38, 50) présentant des parties concaves et convexes sur un côté tourné vers la couche (16, 36) de maintien de film mince, et
dans lequel l'élément de transfert (18, 38, 50) est assemblé de manière sélective à la couche (16, 36) de maintien de film mince sur chacune d'une ou plusieurs couches fonctionnelles (14, 34) parmi une pluralité de couches fonctionnelles (14, 34) sur le premier substrat (10, 30).

10. Le procédé de fabrication d'un dispositif électronique selon la revendication 9, dans lequel la couche (16, 36) de maintien de film mince est formée sur chaque couche fonctionnelle (14, 34) sur le premier substrat (10, 30) dans le processus de formation de la couche (16, 36) de maintien de film mince, et
dans lequel la première couche (11, 31) située sous chaque couche fonctionnelle (14, 34) sur le premier substrat (10, 30) est retirée au cours du processus de retrait de la première couche (11, 31).

11. Le procédé de fabrication d'un dispositif électronique selon l'une quelconque des revendications 1 à 10, dans lequel le dispositif électronique est un dispositif piézoélectrique.

12. Le procédé de fabrication d'un dispositif électronique selon l'une quelconque des revendications 1 à 10, dans lequel le dispositif électronique est un dispositif de conversion photoélectrique.
